# EUROPEAN PATENT SPECIFICATION

(11) **EP 0 839 166 B1**
(45) Date of publication and mention of the grant of the patent: **02.06.2004**
(21) Application number: 96908668.5
(22) Date of filing: 06.03.1996
(51) Int. Cl.: C08L 101/00, C08G 81/00, C08J 3/24

(54) **POLYMERIC COMPOSITION**
POLYMERZUSAMMENSETZUNG
COMPOSITION POLYMERE

(30) Priority: 07.03.1995 US 399724
(43) Date of publication of application: 06.05.1998
(73) Proprietor: Landec Corporation, Menlo Park, CA 94025-1010 (US)
(72) Inventor: BITLER, Stephen, P., Menlo Park, CA 94025 (US); STEWART, Ray F., Redwood City, California 94062 (US); WANTHAL, Mark, A., Redwood City, CA 94065 (US)
(74) Representative: Lunt, Mark George Francis
(86) International application number: PCT/US1996/003023
(87) International publication number: WO 1996/027641

(56) References cited:
- EP-A- 0 018 950
- WO-A-93/21967
- WO-A-94/24219
- US-A- 5 414 058

## Description

This invention relates to polymeric modifying agents having temperature-dependent properties.

It is known to control the rate of a chemical reaction by providing a reactant or a catalyst in a modified form such that the availability of a reactive moiety depends upon some external factor. For example one or more of the reactants, and/or a catalyst, can be encapsulated by a protective shell which at least partly prevents access to the reactant or catalyst. When initiation of the reaction (or an increase in the reaction rate) is desired, the shell is removed or subjected to a treatment which increases the rate at which the reactant or catalyst can permeate through the shell. Removal of the shell can be effected, for example, by means of heat, solvent, or ultrasonic waves. A change in the permeation rate can, for example, be effected by using a shell having temperature-dependent permeability and by changing the ambient temperature; for further details of particularly useful temperature-dependent systems of this kind, reference may be made, for example, to commonly assigned U.S. Patent Nos. 4,830,855 (Stewart), 5,129,180 (Stewart) and 5,254,354 (Stewart), the disclosures of which are incorporated herein by reference for all purposes.

It is also known to use so-called "latent hardeners" or "latent curing agents", optionally in conjunction with "latent accelerators". These "latent" compounds can be mixed with the other ingredients for a crosslinked resin, e.g. an epoxy resin or a polyurethane, to give compositions which are relatively stable at room temperature but which cure rapidly when heated to an elevated temperature, e.g. 160°C or more. Systems of this kind are disclosed for example in US Patent Nos. 4,349,651 (Smith), 4,358,571 (Kaufman et al), 4.420,605 (Kaufman), 4,430,445 (Miyake), 4,659,779 (Bagga et al), 4,689,388 (Hirai et al), 4,701,378 (Bagga et al), 4,742,148 (Lee et al) and 4,933,392 (Andrews et al), and European Patent Publication No. 362787 A2 (Henkel), the disclosures of which are incorporated herein for all purposes.

Many attempts have been made to develop systems which are stable for extended periods at storage temperatures, but which will cure rapidly when heated to give crosslinked polymers having desired properties. However, only limited success has been achieved.

It is also known to prepare polymers containing reactive moieties which will react with other materials under appropriate conditions. For example, in the materials often referred to as "polymer-supported catalysts" the reactive moiety is one which provides a catalytic function. Reference may be made, for example, to Encyclopedia of Polymer Science and Engineering, Vol 2, pages 702-729.

EP 223 045 A2 discloses latent, heat-curable adhesive compositions which are particularly suitable for use with heat shrinkable articles, and which comprise (a) solid particles of a first reactive component, for example an epoxy resin, and (b) solid particles of a second reactive component, for example a material containing reactive amine groups. An essential feature of these compositions is that the particles of the first reactive component exist separately from the particles of the second reactive component.

EP 286734 A discloses the use of certain graft copolymers (including polyethylene having maleic anhydride grafted thereto) as impact modifiers for thermoplastics (including polyamides). For this purpose, the graft polymer is mixed with the thermoplastic in an extruder.

### SUMMARY OF THE INVENTION

We have now discovered, in accordance with this invention, that greatly improved results can be achieved through the use of polymeric materials which comprise (i) a crystalline polymeric moiety which melts over a relatively small temperature range and (ii) an active chemical moiety. Such materials are referred to herein as "modifying agents". We have found that when solid particles of such a modifying agent are dispersed in a matrix, the active chemical moiety is exposed to the matrix only to a limited extent, and therefore, it has little or no effect on the matrix. On the other hand, when the dispersion of the particles in the matrix is heated to the melting point of the crystalline polymeric moiety, there is a rapid increase in the extent to which the matrix is contacted by the active chemical moiety. A similar increase can often be achieved by other treatments, either alone or in conjunction with heating (either simultaneously or sequentially). Such other treatments include for example, one or more of (a) addition of a solvent, (b) exposure to electromagnetic radiation, including visible and ultraviolet light, or to ultrasonic radiation, or (c) increasing or decreasing the pH.

In a first aspect, this invention provides a latent composition which comprises
(1) a first reactive component; and
(2) mixed with the first reactive component, a second reactive component which is in the form of solid particles, and which, when the composition is heated, promotes a chemical reaction of the first reactive component,
characterized in that
I the first reactive component is in the form of a continuous liquid or solid phase matrix material; and
II the second reactive component is a latent modifying agent is in the form of solid particles which
   (a) have an average size of less than 150 microns;
   (b) are composed of a polymeric material which comprises
      (i) a polymeric moiety which comprises a crystalline polymeric moiety having an onset of melting temperature Tₒ and a peak melting temperature Tₚ , Tₚ being greater than 30 °C and such that (Tₚ- Tₒ) is less than Tₚ ^{0.7}, and
      (ii) an active chemical moiety which, when it is brought into contact with the matrix material at a temperature of at least Tₚ, promotes a chemical reaction of the matrix material;
   (c) have some of the active chemical moieties exposed on the surface of the particles and the other active chemical moieties hidden within the particles;
   (e) are contacted by the matrix material; and
   (f) have a heat of fusion of at least 20 J/g; and
      Tₒ and Tₚ being in °C., and Tₒ, Tₚ and the heat of fusion being determined using a differential scanning calorimeter (DSC) at a rate of temperature change of 10 °C/min;
and further characterized in that the composition fulfills at least one of the following conditions:
(A) Tₚ is not more than 100°C;
(B) the polymeric moiety comprises a side chain crystalline polymeric moiety which (i) comprises units derived from one or more monomers containing an n-alkyl group containing 12 to 50 carbon atoms, and (ii) has a peak melting temperature Tₚ of at least 40 °C;
(C) the active chemical moiety catalyzes a chemical reaction of the matrix material; and
(D) the matrix material comprises a cyanoacrylate, epoxy resin, epoxy novolac, unsaturated polyester, cyanate, isocyanate, urethane, acrylic, phenolic, silicone or polysulfide;
whereby, if the composition is heated from Tₒ to a temperature of at least Tₚ, the polymeric moiety melts, thus causing the modifying agent to undergo a physical change which increases the extent of the contact between the matrix material and the active chemical moiety and promotes the chemical reaction of the matrix material.

In a second aspect, this invention provides a method of making a chemical compound which comprises heating a composition according to the first aspect of the invention.

The active chemical moiety is one which promotes a chemical reaction of the matrix under selected conditions. The selected conditions can result directly from the treatment which increases the availability of the active chemical moiety, or they can involve some further change (e.g. a change in temperature, pressure, pH or radiation, or the addition of a solvent or a reactant) that does not substantially reduce the extent to which the matrix is contacted by the active chemical moiety. The active chemical moiety can be (1) a catalytic moiety (i.e. a moiety which reacts chemically (a) with an ingredient of the matrix or (b) with a material which is absorbed into the matrix, and is thereafter regenerated or converted into another compound, and in either case does not form a permanent chemical bond with an ingredient of the matrix); or (2) a reactive moiety (i.e. one which reacts chemically, and forms a permanent chemical bond, with an ingredient of the matrix, and is not regenerated).

In particularly preferred embodiments of the invention, the crystalline polymeric moiety is a side chain crystallizable (SCC) polymer moiety. SCC polymers generally contain side chains comprising substituted or unsubstituted n-alkyl groups of 6 to 50, usually 12 to 50, carbon atoms, derived, for example, from one or more n-alkyl acrylates or methacrylates. The melting point of an SCC polymer is in large measure controlled by the number of carbon atoms in the n-alkyl group or groups and is not (as in most other polymers) heavily dependent on the molecular weight of the polymer or on the presence of other comonomer units (e.g. derived from acrylic acid, acrylonitrile or an unsubstituted or substituted lower alkyl acrylate). Furthermore, SCC polymers generally melt over a small temperature range, e.g. less than 10°C. As a result, it is possible to select an SCC polymer moiety which will cause the modifying agent to melt over a narrow and predetermined range, thus making a sharp change in the extent to which the active chemical moiety contacts the matrix.

As explained in detail below, a number of different factors influence the extent and the speed of the change in the extent to which the active chemical moiety contacts the matrix. These factors include (1) the form of the modifying agent, in particular the size of the particles thereof, (2) the nature of the bond between the polymeric moiety and the active chemical moiety (which is a covalent, ionic, mixed covalent-ionic, or ligand-attached bond, preferably a covalent bond), (3) the value of (Tₚ - Tₒ), which is preferably less than 10°C, (4) the extent and rapidity of the temperature change or other treatment which is carried out in order to promote the chemical reaction of the matrix and (5) the presence of coadditives. Preferably, the combination of these factors results in an increase in the effective concentration of the chemical moiety by a factor of at least 500, particularly at least 1000, especially at least 2,000, with substantially greater increases, e.g. at least 3,000, being obtainable in many cases.

Many of the chemical compounds which can be prepared by the second aspect of the invention are themselves novel. Thus in general, the compounds which result when the modifying agent reacts with the matrix material are novel. Other products which can be prepared in accordance with the present invention, although known as chemical compounds in some forms, are not known in other useful forms, e.g. as foams, which are easily prepared by this invention. Such novel compounds include for example polymers which comprise
(A) first polymeric blocks which comprise a polymeric moiety comprising a crystalline polymeric moiety having an onset of melting temperature Tₒ and a peak melting temperature Tₚ such that Tₚ - Tₒ is less than Tₚ^{0.7}, and
(B) second polymeric blocks which are different from the first polymeric blocks,
the polymer having at least one of the following characteristics
(1) the first polymeric blocks are derived from a modifying agent which has one or both of the following characteristics
   (i) the active chemical moiety is a catalytic moiety, e.g. a moiety containing a tertiary amine, a transition metal or an enzyme, and
   (ii) the modifying agent is in the form of particles preferably having an average diameter of 0.1 to 150, particularly 0.1 to 50, microns;
(2) the polymer is in the form of a foam, an electrically insulating coating on a conductor, a coating on a printed circuit board, a resist on a substrate which is to be plated or etched, an epoxy graphite composite, or a powder coating;
(3) the polymer is crosslinked, preferably thermoset so that it does not flow when heated; and
(4) the second polymeric blocks are derived from at least one monomer selected from epoxides, olefins, and monomers containing a vinyl group substituted on an aromatic ring; and
(5) the linkage between the first and second blocks is derived from a secondary, tertiary or quaternary amine, a heterocyclic amine, especially an imidazole, a carbonyl group, an ester, a free radical-generating group (e.g. an azo or peroxy group which causes vinyl groups to link), or a Lewis acid (e.g. to link epoxy groups).

The compositions of the invention offer a number of important advantages over known compositions. In particular, their improved storage stability means that they can be stored in larger containers and used partially and from time to time; that they may not need to be sealed against the ingress of moisture, etc.; that they may not need to be transported and stored under cooled conditions; and that they can be pumped from a storage area to a manufacturing area. The compositions can also contain other ingredients, for example additives which reduce the viscosity of the composition, surface active agents, including wetting agents, compatibilizers, and melt flow promoting agents.

Many of the temperature-sensitive modifying agents used in this invention are novel compounds and in a third aspect, this invention provides a temperature-sensitive modifying agent which is in the form of solid particles which
(a) have an average size of less than 150 microns;
(b) are composed of a polymeric material which comprises
   (i) a polymeric moiety which comprises a side chain crystalline polymeric moiety having an onset of melting temperature Tₒ and a peak melting temperature Tₚ , Tₚ being greater than 30 °C and such that (Tₚ-Tₒ) to is less than Tₚ ^{0.7} , and
   (ii) an active chemical moiety which comprises a transition metal;
(c) have some of the active chemical moieties exposed on the surface of the particles and the other active chemical moieties hidden within the particles; and
(d) have a heat of fusion of at least 20 J/g;
   Tₒ and Tₚ being in °C., and Tₒ, Tₚ and the heat of fusion being determined using a Differential Scanning Calorimeter (DSC) at a rate of temperature change of 10 °C/min;
Modifying agents used in this invention can for example be prepared by
(I) copolymerizing
   (a) a first monomeric component which comprises one or more monomers which can be polymerized to form a crystalline polymeric moiety having an onset of melting temperature Tₒ and a peak melting temperature Tₚ such that Tₚ - Tₒ is less than Tₚ^{0.7}, and
   (b) a second monomeric component which can be copolymerized with the first component and which comprises one or more monomers containing an active chemical moiety which (i) does not react during the copolymerization and (ii) can catalyze a reaction of a matrix, or can be reacted with a third component to form a group which can catalyze a reaction of a matrix; or
(II)
   (A) providing a polymer which comprises
      (i) a crystalline polymeric moiety having an onset of melting temperature Tₒ and a peak melting temperature Tₚ such that Tₚ - Tₒ is less than Tₚ^{0.7}, and
      (ii) at least one reactive group P; and
   (B) reacting the polymer provided in step (A) with a component which contains at least one reactive group T which will react with the group P and at least one active chemical moiety which (i) does not react during the reaction and (ii) can catalyze a reaction of a matrix, or can be reacted with a third component to form a group which can catalyze a reaction of a matrix; or
(III)
   (A) providing a polymer which contains at least one reactive group Q and a plurality of catalytic moieties which can catalyze a reaction of a matrix, and
   (B) reacting the polymer provided in step A with a component which (i) contains at least one reactive group V which will react with the group Q and (ii) after the reaction, provides a crystalline polymeric moiety having an onset of melting temperature Tₒ and a peak melting temperature Tₚ such that Tₚ - Tₒ is less than Tₚ^{0.7}; or
(IV)
   (A) providing a polymer which contains a plurality of reactive groups R, which may be the same or different, and
   (B) reacting the polymer provided in step A with a first component which (1) contains at least one reactive group W which will react with the group R and (ii) after the reaction, provides a crystalline polymeric moiety having an onset of melting temperature Tₒ and a peak melting temperature Tₚ such that Tₚ - Tₒ is less than Tₚ^{0.7}, and with a second component which contains at least one reactive group X which will react with the group R and at least one active chemical moiety which (i) does not react during the reaction and (ii) can catalyze a reaction of a matrix or can be reacted with a third component to form a group which can catalyze a reaction of a matrix.

The modifying agents used in this invention can for example be converted into particles by
(A) melting the modifying agent, and
(B) forming the molten modifying agent into particles having an average diameter of 0.1 to 150 microns.
In this method, for example, the molten modifying agent can be spray dried, or the molten modifying agent can be mixed with a suitable heated matrix and then cooled so that the modifying agent solidifies in the form of particles dispersed in the matrix.

### DETAILED DESCRIPTION OF THE INVENTION

In this specification, parts and percentages are by weight, temperatures are in °C, and Tₒ, Tₚ and heat of fusion are determined using a DSC calorimeter (at a rate of temperature change of 10°C/min). The abbreviation CxA is used to denote an n-alkyl acrylate in which the n-alkyl group contains x carbon atoms, the abbreviation Cx alkyl is used herein to denote an n-alkyl group which contains x carbon atoms, and the abbreviation Cx IEMA is used to denote n-alkyl oxyycarbonylamidoethyl methacrylates in which the n-alkyl group contains x carbon atoms.

### Matrix Materials

The terms "matrix" and "matrix material" are used in this specification to denote any material or mixture of materials which can provide the continuous phase in which the modifying agent is distributed. Such a matrix can include, in addition to the modifying agent, one or more other materials which are distributed in the continuous phase of the matrix, for example dissolved or dispersed in the form of particles in the continuous phase. The invention is particularly useful for matrix materials which are polymerized and/or crosslinked when they are exposed to the active chemical moiety in the modifying agent. These matrix materials include for example cyanoacrylates, epoxy resins, epoxy novolacs, unsaturated polyesters, cyanates, urethanes, acrylics and phenolics. Compositions comprising such polymerizable materials are well known and are disclosed for example in:
(a) Handbook of Epoxy Resins by Henry Lee and Kris Neville; 1967; McGraw-Hill Inc.
(b) Epoxy Resins, Chemistry and Technology 2nd Edition, edited by Clayton A. May; 1988; Marcel Dekker, Inc.(c) Polyurethanes, Chemistry, Technology and Applications by Z. Wirpsza; 1993; Ellis Norwood Ltd.(d) The ICI Polyurethanes Book by George Woods; 1987; John Wiley & Sons, Inc. (e) Structural Adhesives, Chemistry and Technology, edited by S. R. Hartshort; 1986; Plenum Press (f) Test Methods for Epoxy Compounds; published by the Society of the Plastics Industry, Inc., Epoxy Resin Formlations Division (g) Thermal Characterization of Polymeric Materials, edited by Edith A. Turi; 1981; Academic Press, Inc., and (h) Reaction Polymers, edited by Wilson F. Gum et al, Hanser Publishing. A specific example of such a material is the epoxy resin available from Shell Corp. under the trade name Epon 828. Where these known compositions contain hardeners (or curing agents) and/or accelerators (including latent hardeners and/or latent accelerators) and/or toughening agents and/or other ingredients which provide desired properties in the end products, the modifying agents can be used in addition to, or to replace all or part of, such ingredients. Thus the modifying agent may be used to enhance the properties of other components in the matrix. For example, in an epoxy matrix containing dicyandiamide (DICY) or an anhydride, the modifying agent may cause the composition to cure at a lower temperature and/or at a faster speed. Other matrix materials are compositions which comprise enzymes and other biologically active materials, e.g. liquid or solid samples obtained from mammals or compositions containing or derived from such samples, which may be contacted with the modifying agent, e.g. as part of a medical diagnostic test.

The matrix may be the sole material which takes part in the chemical reaction which is promoted by the chemical moiety, or the chemical reaction can involve an additional material, including the coadditives discussed below, which is added before or after the modifying agent is treated to change the extent to which the active chemical moiety is exposed to the matrix.

### Polymeric Moieties

The polymeric moiety in the modifying agent can be derived from a single polymer or from a mixture of polymers, and the polymer can be a homopolymer, or a copolymer of two or more comonomers, including random copolymers, graft copolymers, block copolymers and thermoplastic elastomers. Preferably at least part of the polymeric moiety is derived from a side chain crystallizable (SCC) polymer. The SCC polymer may for example be derived from one or more acrylic, methacrylic, olefinic, epoxy, vinyl, ester-containing, amide-containing or ether-containing monomers. The molecular weight of an SCC polymer is relatively unimportant to its Tₚ, but is generally an important factor in determining the Tₚ of other polymers. The preferred SCC polymeric moieties are described in detail below. However, the invention includes other crystalline polymers having the desired properties. Such other polymers include for example polymers in which the crystallinity results exclusively or predominantly from the polymer backbone, e.g. polymers of α-olefins containing 2 to 12, preferably 2 to 8, carbon atoms, e.g. polymers of monomers having the formula CH₂ = CHR, where R is hydrogen, methyl, propyl, butyl, pentyl, 4-methylpentyl, hexyl or heptyl, as well as other polymers such as polyesters, polyamides, and polyalkylene oxides, for example polytetrahydrofuran.

Even with SCC polymers, the molecular weight of the polymeric moiety is an important factor in determining the rate at which the modifying agent diffuses through the matrix, especially after it has been heated or otherwise treated to increase the availability of the reactive moiety. Thus in general a low molecular weight is to be preferred; however, too low a molecular weight may result in excessive exposure of the reactive moieties at temperatures below Tₚ. We have obtained good results with modifying agents having an Mn of 1,000 to 100,000, preferably 1,000 to 50,000, more preferably 1,000 to 20,000, particularly 1,000 to 10,000. Another factor in determining the rate at which the modifying agent mixes with the matrix is the difference between the solubility parameters of the matrix (δ₁) and the modifying agent (δ₂). Preferably the difference between δ₁ and δ₂ is not more than the difference between the solubility parameters of Epon 828 and the homopolymer of C₂₂ acrylate. Another factor in determining the rate at which the modifying agent mixes with the matrix at temperatures below Tₚ is its crystallinity; the greater the crystallinity, the lower the rate. Thus an increase in crystallinity generally increases the stability of the composition at temperatures below Tₚ, but generally does not change the reactivity or catalytic activity of the modifying agent at temperatures above Tₚ. A crystallinity such that the DSC heat of fusion is at least 10 J/g, particularly at least 20 J/g, is preferred. The steric nature of the polymeric moiety can also be significant in determining the availability of the active moiety, especially when it is a stereospecific catalyst.

It is important that the polymeric moiety should melt over a relatively small temperature range, so that the extent to which the matrix is contacted by the active chemical moiety changes sharply when the composition is heated or cooled through the temperature range Tₒ to Tₚ. The closer Tₚ is to room temperature (which for most compositions is the expected or preferred storage temperature), the more rapid the transition should preferably be. Thus Tₚ - Tₒ is preferably less than Tₚ^{0.7}, particularly less than Tₚ^{0.6}, Tₒ and Tₚ being in °C. Table 1 below shows (in °C) the preferred and particularly preferred values of Tₚ - Tₒ for various values of Tₚ.

**TABLE 1**

| Tₚ | Tₚ-Tₒ = Tₚ^{0.7} | Tₚ-Tₒ = Tₚ0.6 |
|---|---|---|
| | | |
| 30 | <10.8 | <7.6 |
| 40 | <13.2 | < 9.1 |
| 50 | <15.5 | <10.6 |
| 60 | <17.5 | <17.6 |
| 70 | <1 9.5 | <12.8 |
| 90 | <23.3 | <14.9 |
| 120 | <28.5 | <17.7 |
| 150 | <33.3 | <20.2 |

Tₚ can vary widely, depending on the conditions under which the composition is to be stored and the temperature to which it can conveniently be heated in order to promote exposure of the matrix to the active chemical moiety. Thus in general, Tₚ may be for example 10 to 150°C. For compositions which are to be stored at room temperature (typically 20-30°C), Tₚ is preferably at least 40°C, particularly at least 45°C, but not more than 100°C, particularly not more than 85°C, so that the modifying agent can be activated by moderate heating above room temperature. Tₚ-Tₒ is preferably less than 10°C, particularly less than 8°C, more particularly less than 6°C, especially less than 4°C.

### Preferred SCC polymer moieties

SCC polymer moieties which can be used in this invention include moieties derived from known SCC polymers, e.g. polymers derived from one or more monomers such as substituted and unsubstituted acrylates, methacrylates, fluoroacrylates, vinyl esters, acrylamides, methacrylamides, maleimides, α-olefins, p-alkyl styrenes, alkylvinyl ethers, alkylethylene oxides, alkyl phosphazenes and amino acids; polyisocyanates; polyurethanes; polysilanes; polysiloxanes; and polyethers; all of such polymers containing long chain crystallizable groups. Suitable SCC polymers are described for example in J. Poly. Sci. 60, 19 (1962), J. Poly. Sci, (Polymer Chemistry) 7,3053 (1969), 9, 1835, 3349, 3351, 3367, 10, 1657, 3347,18, 2197, 19, 1871, J. Poly. Sci, Poly-Physics Ed 18 2197 (1980), J. Poly. Sci, Macromol. Rev, 8, 117 (1974), Macromolecules 12, 94 (1979), 13, 12, 15, 18, 2141, 19, 611, JACS 75, 3326 (1953), 76; 6280, Polymer J 17, 991 (1985); and Poly. Sci USSR 21, 241 (1979).

The SCC polymer moieties which are preferably used in this invention can be broadly defined as moieties which comprise repeating units of the general formula 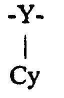 where Y is an organic radical forming part of the polymer backbone and Cy comprises a crystallizable moiety. The crystallizable moiety may be connected to the polymer backbone directly or through a divalent organic or inorganic radical, e.g. an ester, carbonyl, amide, hydrocarbon (for example phenylene), amino, or ether link, or through an ionic salt linkage (for example a carboxyalkyl ammonium, sulfonium or phosphonium ion pair). The radical Cy may be aliphatic or aromatic, for example alkyl of at least 10 carbons, fluoralkyl of at least 6 carbons or p-alkyl styrene wherein the alkyl contains 6 to 24 carbons. The SCC moiety may contain two or more different repeating units of this general formula. The SCC may also contain other repeating units, but the amount of such other units is preferably such that the total weight of the crystallizable groups is at least equal to, e.g. twice, the weight of the remainder of the block.

Preferred SCC moieties comprise side chains containing in total at least 5 times as many carbon atoms as the backbone of the moiety, particularly side chains comprising linear polymethylene moieties containing 12 to 50, especially 14 to 22, carbon atoms. or linear perfluorinated or substantially perfluorinated polymethylene moieties containing 6 to 50 carbon atoms. Polymers containing such side chains can be prepared by polymerizing one or more corresponding linear aliphatic acrylates or methacrylates. or equivalent monomers such as acrylamides or methacrylamides. A number of such monomers are available commercially, either as individual monomers or as mixtures of identified monomers, for example C12A, C 14A, C16A, C18A, C22A, a mixture of C 18A, C20A and C22A, a mixture of C26A to C40A, fluorinated C8A (AE800 from American Hoechst) and a mixture of fluorinated CBA, C10A and C12A (AE12 from American Hoechst). The polymers can optionally also contain units derived from one or more other comonomers preferably selected from other alkyl, hydroxyalkyl and alkoxyalkyl acrylates, methacrylates (e.g. glycidal methacrylate), acrylamides and methacrylamides; acrylic and methacrylic acids; acrylamide; methacrylamide; maleic anhydride; and comonomers containing amine groups. Such other co-monomers are generally present in total amount less than 50%, particularly less than 35%, especially less than 25%, e.g. 0 to 15%. They may be added to modify the melting point or other physical properties of the polymers. The melting point of a polymer containing such polymethylene side chains is influenced by the number of carbon atoms in the crystallizable side chains. For example, homopolymers of C14A, C16A, C18A, C20A, C22A, C30A, C40A and C50A respectively typically have melting points of 20, 36, 49, 60, 71, 76, 96 and 102°C, while the homopolymers of the corresponding n-alkyl methacrylates typically have melting points of 10, 26, 3 9, 50, 62, 68, 91 and 95°C. Copolymers of such monomers generally have intermediate melting points. Copolymers with other monomers, e.g. acrylic acid or butyl acrylate, typically have somewhat lower melting points.

Other polymers which can provide SCC moieties for use in this invention include atactic and isotactic polymers of n-alkyl α-olefins (e.g. the atactic and isotactic polymers of C₁₆ olefin, having Tₘ's of 30° and 60°C respectively); polymers of n-alkylglycidyl ethers (e.g. the polymer of C₁₈ alkyl glycidylether); polymers of n-alkyl vinyl ethers (e.g. the polymer of C₁₈ alkylvinylether having a Tₘ of 55°C); polymers of n-alkyl-α-epoxides (e.g. the polymer of the C₁₈ alkyl α-epoxide having a Tₘ of 60°C); polymers of n-alkyl oxycarbonylamido-ethylmethacrylates (e.g. the polymers of C18 IEMA, C22 IEMA and C30 IEMA having Tₘ's of 56°, 75° and 79° respectively); polymers of n-fluoro alkyl acrylates (e.g. the polymers of C₈ hexadecafluoroalkylacrylate, and of a mixture of C₈₋₁₂ alkyl fluoroacrylates having Tm's of 74° and 88°C respectively), polymers of n-alkyloxazolines (e.g. the polymer of C₁₆ alkyl oxazoline having a Tₘ of 155°C); polymers obtained by reacting an hydroxyalkyl acrylate or methacrylate with an alkyl isocyanate (e.g. the polymers obtained by reacting hydroxyethyl acrylate with C₁₈ or C₂₂ alkyl isocyanate and having Tₘ's of 78° and 85° respectively); and polymers obtained by reacting a difunctional isocyanate, a hydroxyalkyl acrylate or methacrylate, and a primary fatty alcohol (e.g. the polymers obtained by reacting hexamethylene diisocyanate, 2-hydroxyethyl acrylate, and C₁₈ or C₂₂ alcohols, and having Tₘ's of 103° and 106°C respectively).

Preferred SCC polymer moieties used in this invention comprise 30 to 100%, preferably 40 to 100%, of units derived from at least one monomer selected from the group consisting of alkyl acrylates, alkyl methacrylates, N-alkyl acrylamides, N-alkyl methacrylamides, alkyl oxazolines, alkyl vinyl ethers, alkyl vinyl esters, α-olefins, alkyl 1,2-epoxides and alkyl glycidyl ethers in which the alkyl groups are n-alkyl groups containing 12 to 50 carbon atoms, and the corresponding fluoroalkyl monomers in which the thennoalkyl groups are n-fluoroalkyl groups containing 6 to 50 carbon atoms; 0 to 20% of units derived from at least one monomer selected from the group consisting of alkyl acrylates, alkyl methacrylates, N-alkyl acrylamides, alkyl vinyl ethers, and alkyl vinyl esters in which the alkyl groups are n-alkyl groups containing 4 to 12 carbon atoms; and 0 to 15% of units derived from at least one polar monomer selected from the group consisting of acrylic acid, methacrylic acid, itaconic acid, acrylamide, methacrylamide, acrylonitrile, methacrylonitrile, vinyl acetate and N vinyl pyrrolidone. Such SCC moieties may also contain units derived from other monomers to change compatibility with the matrix, or to raise the modulus of a reaction product containing the modifying agent; such monomers include styrene, vinyl acetate, monoacrylic functional polystyrene and the like.

The number average molecular weight of the SCC polymer moiety is preferably less than 200,000, more preferably less than 100,000, particularly less than 50,000, more particularly 1,000 to 20,000. The molecular weight of the SCC polymer moiety can be adjusted (for example through choice of the reaction conditions and addition of chain transfer agents) so as to optimize the reactivity of attached moieties without substantial change in Tₚ.

When the polymeric moiety becomes incorporated in the final product, especially when it becomes chemically linked to the matrix, e,g. incorporated in a crosslinked polymeric structure, its presence often has an effect on the properties of the final product. Preferably, therefore, it is selected so as to provide improved properties, for example an improvement in tensile strength, elongation, toughness, flexibility, adhesion (e.g. to steel, glass, wood or polyethylene or other organic polymer), or resistance to degradation by moisture or other chemicals, pests, mildew, fungus, light or other electromagnetic radiation, heat or burning. For example, we have found that when a crosslinked epoxy resin is prepared using a modifying agent in which the crystalline moiety is an SCC polymer, the toughness and/or adhesive strength of the resin can be enhanced. In one embodiment, the modifying agent comprises, in addition to a crystalline moiety, a second polymeric moiety which becomes covalently linked, through the reactive moiety, to a polymer, e.g. crosslinked polymer, and which imparts desired properties to the final product. The second polymeric moiety may be for example an amorphous moiety or a crystalline moiety having a melting point higher or lower than Tₚ. In one embodiment, the polymeric moiety comprises a thermoplastic elastomer (TPE) moiety in which the active chemical moiety is attached to the hard block, and the soft blocks have a toughening effect on the final product. For example, the TPE can include SCC hard blocks and amorphous soft blocks. The SCC hard blocks can for example be derived from SCC polymers as described above. The amorphous soft blocks can for example have a T_{g} of -60 to 150°C, preferably -60 to 120°C. Suitable soft blocks can for example be derived from one or more of butyl acrylate, ethyl hexylacrylate, and butadiene. Suitable SCC TPE's to which active chemical moieties can be attached are disclosed for example in commonly assigned US Patent Application Serial Nos. 07/773,047, 07/957,270 and 08/048,280 (Docket Nos. 9213, 9213-1 and 9213-2) and in published PCT Application Nos. PCT/US92/08508 and PCT/US94/04138 (Docket Nos. 9213-1-PCT and 9213-2-PCT), the disclosures of which are incorporated herein by reference.

### Active Chemical Moieties

The selected active chemical moiety can be a catalytic moiety, a reactive moiety, or an inhibiting moiety. The way in which a moiety behaves (i.e. as a catalytic, reactive, or inhibiting moiety) may depend upon the matrix material: for example, an amine group may be catalytic in some circumstances and reactive in other circumstances. The modifying agent preferably contains at least 5%, particularly at least 10%, of the active chemical moiety. The modifying agent can contain two or more different active chemical moieties, in which case each can be a catalytic moiety, or each can be a reactive moiety, or one or more can be a catalytic moiety and the other or others a reactive moiety. The active chemical moiety can contain, for example, nitrogen, e.g. as a primary, secondary, tertiary or quaternary amine, or as an imidazole or other cyclic structure containing nitrogen; phosphorus, e.g. as a -PR₃ group, where R is an organic radical; oxygen, e.g. as a carboxyl, ester or amide group; or a metal or metal-containing group, e.g. a transition metal such as rhodium or a main group metal such as aluminum or tin, or a metal alkoxide, attached to the polymeric moiety through one or more ligand groups.

Chemical moieties which are particularly useful in this invention include amines (including primary, secondary, tertiary and quaternary amines, and heterocyclic amines such as imidazoles); carboxyl groups; sulfonate groups; phosphines; main group metals, including tin; transition metals, including titanium and rhodium, e.g. as [(C₂H₄)₂ RhCl]₂, and acetylacetonate esters of transition metals; enzymes; superacids; metal alkoxides; UV-activated moieties, e.g. 4-vinylbenzophenone; Michler's ketone; and acetophenone; and groups which are converted into such groups when the modifying agent is used.

### Modifying Agents Containing Catalytic Chemical Moieties

The invention can make use of any modifying agent in which a catalytically active chemical moiety is bonded to a temperature-sensitive polymeric moiety. Reactions which can be catalyzed by such modifying agents include polymerizations, e.g. polymerizations of one or more olefinically unsaturated monomers (particularly one or more olefins, optionally with one or more substituted olefins), and ring-opening polymerizations, hydrogenations, hydroformylation reactions, enzyme-catalyzed reactions (e.g. in the production of foods, including cheese, and pharmaceuticals, in medical diagnostic procedures, and in the treatment of waste products), oxidations, reductions, etc. The catalytic modifying agent can remain in the catalyzed reaction mass, or, in a preferred embodiment, the catalyzed reaction mass is one which is fluid while the reaction is taking place and remains fluid when it is cooled and/or treated in some other way, e.g. by addition of another ingredient, so that the catalytic modifying agent precipitates out as a solid and can be removed, e.g. by filtration or centrifuging. The recovered catalytic modifying agent can then be used again. The modifying agent can optionally be retained in the reaction vessel by filtration within the vessel, to which fresh matrix material is then added before heating (or otherwise treating) the modifying agent to reexpose the catalytic moieties.

One example of a catalytic modifying agent is one obtained by attaching rhodium (a transition metal) to a polymer prepared by the technique disclosed in JACS 100 264 (1978), Stille et al, the disclosure of which is incorporated by reference, using a monomer like C18A or C22A (or other SCC polymer precursor) in place of the styrene or hydroxyethyl acrylate used by Stille. The resulting modifying agent could be used, at a temperature above Tₚ, to catalyze a reaction, for example the hydrogenation of an alkene, e.g. hydrogenation of α-N-acylaminoacrylic acid to the corresponding amino acid.

Another example of a catalytic modifying agent is one containing an enzyme, for example an enzyme attached to the polymeric moiety through formation of a Schiff base (e.g. through reaction of a primary amine on the enzyme with an aldehyde group on the polymer, for example on a unit derived from acrolein, copolymerized with one or more SCC precursor monomers). A suitable enzyme is for example B-galactosidase, which, at a temperature above Tₚ, but not at a temperature below Tₒ, would react with D-thiogalactopyranoside IPTG, as could be observed by a color change from white to blue.

Another example of a catalytic modifying agent is one containing a free radical initiating group, or a group which becomes a free radical initiating group (a) through reaction with an ingredient of the matrix material or (b) as a result of (i) the treatment which exposes the active chemical moiety or (ii) a further treatment. For example, the matrix material can be a photopolymerizable polymeric composition and the active chemical moiety can be a free radical initiator. Such a composition will not polymerize when exposed to light while the modifying agent is in solid particulate form, or when the composition is heated in the absence of light, but will polymerize rapidly when exposed to light while it is being heated or after it has been heated. The modifying agent can contain only the active chemical moiety which is needed to initiate the reaction or it can in addition contain a reactive group so that it becomes chemically bonded to the matrix material.

### Modifying Agents Containing Reactive Chemical Moieties

This invention can make use of any modifying agent in which a reactive chemical moiety is bonded to a temperature-sensitive polymeric moiety. The reactive moiety reacts, and forms a permanent chemical bond, with at least one ingredient of the matrix in which the modifying agent is distributed.

Examples of reactive chemical moieties, and monomers from which they may be derived, include (a) isocyanato [as in isocyanatoethylmethacrylate (IEMA), methacryloylisocyanate (MAI) and isopropenyl dimethyl benzyl isocyanate (TMI)]; (b) anhydride [as in maleic anhydride and itaconic anhdride); (c) acyl halide [as in methacryloyl chloride and acryloyl chloride]; (d) aldehyde [as in acrolein and methacrolein]; (e) hydroxyl [as in hydroxy ethyl acrylate (HEA) or methacrylate and hydroxy butyl acrylate or methacrylate]; (f) alkyl or aryl halide [as in vinyl benzyl chloride (VBC)]; (g) amide [as in acrylamide and methacrylamide]; (h) amine, including saturated and unsaturated heterocyclic amine [as in dimethyl aminoethyl acrylate or methacrylate, vinyl imidazole and 1-(2-aminoethyl)imidazole attached through IEMA]; (i) carboxyl [as in acrylic or methacrylic acid]; (j) primary or secondary amines [as in triethylenetetraamine connected through IEMA or GMA or maleic anhydride]; (k) epoxide [as in glycidyl acrylate or methacrylate )GMA)]; (1) mercaptan connected through multiple bonds; (m) azo and peroxy [as in 4,4'-azobis (4-cyanovaleric acid) or 4,4'-azobis (4-cyanovaleroyl chloride) connected through HEA]; and (n) carbamate and urea [as in amino functional and hydroxy functional compounds, e.g. 1-(2-aminoethyl)imidazole and 1-(2-hydroxyethyl)imidazole connected through IEMA].

The present invention is particularly useful for the provision of compositions comprising two or more ingredients which will react with each other at a rate which is comparatively slow (and preferably negligible for practical purposes) below a particular temperature, but which will react with each other rapidly when the composition is heated to a temperature which is above, but not necessarily far above, that temperature. Such compositions can be stored for extended periods below that temperature, but will react rapidly when heated above that temperature. Compositions of this kind are often referred to as "latent", "one part" or "one package" formulations. Preferred compositions of the present invention (whether the modifying agent contain a reactive or a catalytic chemical moiety) can be stored for at least 1 month, and preferably at least 6 months, at 40°C without doubling in viscosity, but will cure, preferably at a rate such that they do not flow in at most 1 hour, when heated to a temperature substantially over Tₚ. They are particularly useful as adhesives, coatings, compositions for impregnating fabrics, e.g. glass fiber fabrics, to produce materials often referred to as "prepregs", compositions for creating foams, and compositions for use in reaction injection molding (RIM) and sheet molding compound (SMC) applications. The matrix materials in one-part formulations may be for example epoxies, epoxy novolacs, cyanates, isocyanates, urethanes, acrylics, phenolics, cyanoacrylates, silicones, unsaturated polyesters, polysulfides, and other precursors for thermoset polymers.

The reactive modifying agent may alternatively or additionally produce a color change in the matrix, by bleaching it or by reacting to form a leuco dye or other colored product, e.g. as part of a medical diagnostic system, for example a system in which an enzyme reacts with an active chemical moiety, or an enzyme (as the active chemical moiety) promotes or inhibits a reaction of the matrix. For example, the active chemical species may react to form an intensely colored species, as in leuco dye formation as applied to colorimetric indicating systems.

Although the modifying agents are particularly useful in one-part formulations, the invention includes their use in processes in which at least one of the ingredients for the finished product is added during or after the treatment which increases the availability of the reactive chemical moiety.

### Mixtures of Modifying Agents

Two or more modifying agents can be used together, differing in the active chemical moiety or the polymeric moiety or both. When the polymeric moieties differ, the reaction can be carried out in one step at a temperature above the activation temperature of both (or all of the) modifying agents, or in two or more steps at increasing (or decreasing) temperatures selected to activate one or more desired modifying agents. In this way, for example, a first step can be carried out with one catalyst or reactant at a desired concentration, and a second step with the same catalyst or reactant at a higher (or lower) concentration, or with the first catalyst or reactant and a second catalyst or reactant. When a catalyst is used, the second catalyst can catalyze the same reaction as the first catalyst or a different reaction; in the latter case, the second catalyst can be at a concentration such that the reaction catalyzed by the first catalyst is inhibited. We believe that such mixtures may be particularly useful in medical diagnostic kits.

### Bond Between the Polymeric and Active Moieties of the Modifying Agent

The strength of the bond between the polymeric moiety and the active chemical moiety is an important factor in determining the rate at which the matrix is contacted by the active moiety. Generally, the stronger the bond, the less the contact at temperatures below Tₚ, and the better the storage stability (or "latency"). On the other hand, weaker bonds may promote rapid reaction near and above Tₚ. Covalent bonds are generally preferred, particularly those having a bond strength of at least 10 Kcal/mole, because they do not undergo reversible disassociation (as do ionic and Van der Waal bonds), and, therefore, provide better storage stability. However, modifying agents in which the bonds are partially covalent and partially ionic, or ionic, can also be useful, especially if the required latency period is short.

### Physical Form of the Modifying Agent

The modifying agent is in the form of solid particles which are uniformly dispersed in a solid or liquid matrix. The smaller the particles are, the easier they are to disperse and maintain in a uniformly dispersed state. On the other hand, the smaller the particles, the lower the ratio of active chemical moieties hidden within the particles to those exposed on the surface of the particles, and the less the potential storage stability of the composition. This ratio decreases as the size of the particles decreases and also is higher for spherical particles than for particles of other shapes. It is, therefore, preferred to use substantially spherical particles having an average size of 0.1 to 50, particularly 0.1 to 25, especially 0.1 to 10, microns. Preferably each of the particles is within these ranges. Suitable particles can be produced by known techniques, including spray drying, impact pulverizing, and agitation in a fluid followed by cooling to freeze the particle size. If the particles employed are not spherical, preferably their ratio of external area to volume corresponds to these ranges.

### Relative Amounts of Modifying Agent and Matrix

The relative amounts of modifying agent and matrix may vary widely, depending on the concentration of the active chemical moiety in the modifying agent, the conditions to which the composition is subjected, and the desired result. Generally the composition contains 0.01 to 50% of the modifying agent. When the active chemical moiety is a catalytic moiety, the modifying agent preferably contains 1 to 40% thereof, particularly 1 to 10% thereof. When the active chemical moiety is a reactive moiety, preferably the modifying agent contains at least 5%, more preferably at least 15%, particularly at least 20%, e.g. 15 to 40%, especially 20 to 35%, thereof.

### Process Characteristics

The modifying agent can be dispersed in the matrix in any desired way. The resulting composition is then maintained at a temperature below Tₚ until the time comes to promote or inhibit the chemical reaction. Heating and cooling are the preferred ways of changing the extent to which the matrix is contacted by the active chemical moiety. However, other measures can be used in addition to, or instead of, heating or cooling. For example, a solvent can be added, the concentration of a solvent can be changed (including the addition of a non-solvent), or an ingredient can be added to raise or lower the pH of the composition, or the composition can be exposed to ultra-violet light or other suitable electromagnetic radiation, or to ultrasonic radiation. Heating can be effected by external heating, e.g. by radiant heat or with a hot air gun, or by heat generated internally, e.g. radio frequency, ultrasonic, resistance or induction heating. The composition may contain, or be placed adjacent to, a material which is selected to provide or enhance such heating, e.g. graphite or carbon black dispersed in the composition, or electrical resistance heating means, e.g. metal or graphite wires, plates or other members within the thickness of, or adjacent to, the composition. The composition is preferably heated to at least Tₚ, particularly at least (Tₚ + 5)°C. If desired, the composition can be agitated or otherwise treated during or after the heating, in order to increase the rate at which the active chemical moiety is exposed to the matrix.

### Coadditives

The compositions of the first aspect of the invention can contain one or more other ingredients which have a useful effect, and which are referred to herein as coadditives. For example, such an ingredient can (a) help to achieve good distribution of the solid modifying agent in the matrix material and/or reduce the time needed to distribute the solid modifying agent in the matrix; (b) help to stabilize the composition before the treatment which exposes the active chemical moiety; (c) have a desired effect on the manner or extent to which the active chemical moiety is exposed by such treatment; (d) have a desired effect on a chemical reaction which takes place after such treatment, e.g. to increase the rate of reaction and/or to lower the temperature at which the reaction takes place; or (e) have a desired effect on the product of such a chemical reaction, e.g. on its stability or its physical characteristics such as strength, toughness, flexibility, color or surface smoothness. A single coadditive can perform two or more of these functions. The total amount of coadditive is preferably 0.05 to 50%, based on the "formula weight". The term "formula weight" is used herein to denote the combined weight of the modifying agent and the matrix, but excluding any non-reactive, e.g. inorganic, fillers.

Specific examples of useful coadditives are (a) partial salts of acidic polyesters, e.g. the material sold under the trade name W-990 by Byk Chemie; (b) methylalkyl polysiloxanes modified by polyethers, e.g. the material sold under the trade name A-530 by Byk Chemie; (c) phenols, including n-alkyl phenols in which the n-alkyl group contains 6 to 20 carbon atoms, e.g. nonyl phenol, 3-pentadec-8-ene-1-yl phenol, e.g. the material sold under the trade name NC-700 by Cardolite, and bisphenol A, (d) glycidyl ethers of phenols, including the phenols just noted, including. 3-pentadec-8-ene-1-yl phenyl glycidyl ether, e.g. the material sold under the trade name NC-513 by Cardolite, and nonyl phenyl glycidyl ether, e.g. the material sold under the trade name Heloxy Modifier 64 by Shell Chemical; (e) polyfunctional epoxy resins, including oxirane, 2,2'-((1-methylethylidene) bis (4,1-phenyleneoxy(1-(butoxymethyl)-2,1-ethanediyl) oxymethylene))bis-, e.g. the material sold under the trade name XB-4122 by Ciba-Geigy, 4-(8-(4-glycidyl phenyl) pentadecanyl) phenyl glycidyl ether, e.g. the material sold under the name NC-514 by Cardolite, 4-(pentadecan-8,9,oxo-1-yl) phenyl glycidyl ether, e.g. the material sold under the trade name NC-551 by Cardolite, and the polyglycidyl ether of an alkenyl phenol formaldehyde novolac resin, e.g. the material sold under the trade name NC-547 by Cardolite; (f) secondary alcohol ethoxylates, e.g. the material sold under the trade name Tergitol 15-S-3 by Union Carbide; (g) quaternary alkyl ammonium halides, e.g. di-hexadecyldimethyl ammonium chloride and alkyl benzyl dimethyl ammonium chlorides; (h) fatty acid and amides thereof; and (i) dimer acids. Other surface active agents are listed in McCucheon's Handbook of Emulsifiers and Detergents.

Many of the useful coadditives are surface active agents comprising (a) one or more groups which are compatible with the modifying agent, and (b) one or more groups which are compatible with the matrix or with a product of a chemical reaction of the matrix after the modifying agent has been exposed. Such coadditives can be small molecules, oligomers or polymers, e.g. block copolymers. Groups of type (a) include non-polar groups such as alkyl, fluoroalkyl, and alkyl styrene groups wherein the alkyl group contains at least 6, preferably at least 9, e.g. 9 to 50, carbon atoms and is preferably an n-alkyl group. Groups of type (b) include groups in the matrix material, e.g. the group or groups which take part in a polymerization or crosslinking reaction when the solid modifying agent is exposed, for example a polar group such as an epoxy, hydroxyl, carboxyl, amine, ammonium, ether ester, amide, sulfonamide, sulfonic acid, sulfonic acid salt or phosphate group. For matrix materials which are epoxy resins, preferred surface active agents have an HLB ratio (the ratio of hydrophilicity to lipophilicity) less than 10.

One class of coadditives can be classified as viscosity-reducing additives. These reduce the viscosity of the matrix material so that dispersion of a modifying agent therein is achieved more rapidly and/or more efficiently. The improved dispersion can be achieved when the solid modifying agent is dispersed in the matrix material and/or when the solid modifying agent is heated (and/or otherwise treated) to increase the exposure of the active chemical moiety. The amount of viscosity-reducing agent is preferably 1 to 50%, based on the formula weight. For matrix materials which are epoxy resin precursors, suitable viscosity-reducing agents include alkyl, preferably C₁₂₋₁₄ alkyl glycidyl ethers, nonyl phenyl glycidyl ether and dimer fatty acid diglycidyl ester, e.g. the materials sold under the trade names Heloxy Modifier 8, Heloxy Modifier 64 and Heloxy Modifier 71 respectively by Shell Chemical; epoxidized alpha olefins, e.g. the materials sold under the trade names Vikolox 14 and Vikolox 18 by Elf Atochem North America; oxirane, 2,2'-((1-methylethylidene)bis(4, -phenyleneoxy( -(butoxymethyl)-2,1 - ethanediyl)oxymethylene))bis-, e.g. the material sold under the trade name XB-4122 by Ciba-Geigy; and 3-pentadec-8-ene-1-yl phenyl glycidyl ether, e.g. the material sold under the trade name NC-513 by Cardolite and 4-(8-(4-glycidyl phenyl) pentadecanyl) phenyl glycidyl ether, e.g. the material sold under the name NC-514 by Cardolite; and 4-(pentadecan-8,9,oxo-1-yl) phenyl glycidyl ether, e.g. the material sold under the trade name NC-551 by Cardolite.

Another class of additives can be classified as melt flow agents. These associate with the modifying agent so that it flows more easily after it has been treated to expose the active chemical moiety. The melt flow agent can for example plasticize the polymeric moiety so that the polymeric chains are more mobile. In one embodiment, the polymeric moieties tend to form hydrogen bonds with each other, and the melt flow promoting agent is a compound which forms hydrogen bonds with the polymeric moieties, thus reducing the extent of the hydrogen bonding between them. Melt flow agents can be used in amount 1 to 50%, e.g. 5 to 20%, based on the formula weight. Examples of melt flow agents are dioctyl phthalate, dioctyl adipate, stearamide, butyl acetate, epoxidized soybean oil (e.g. the material sold under the trade name Vicoflex 7170 by Atochem), n-ethyl-o,p-toluene sulfonamide (e.g. the material sold under the trade name Santicizer 8 by Monsanto, and the material sold under the trade name NC700 by Cardolite.

Another class of additives can be classified as compatibilizers. These improve the compatibility of the modifying agent and the matrix material, and thus allow more intimate contact and mixing. Compatibilizers are preferably used in amount 1 to 50%, based on the formula weight. Examples of compatibilizers are block copolymers comprising units derived from one or more alkyl acrylates and one or more glicidyl ethers, e.g. a block copolymer of tetradecylacrylate and phenyl glicidyl ether; block copolymers comprising units derived from one or more alkyl acrylates and styrene, e.g. a block copolymer of tetradecyl acrylate and styrene; and epoxy novolacs, e.g. that available under the trade name NC-547 from Cardolite.

The effect produced by a particular coadditive will depend upon the amount thereof, the matrix material and the modifying agent. However, those skilled in the art will have no difficulty, having regard to their own knowledge and the disclosure in this specification, in selecting suitable coadditives.

### Use of the Modifying Agents in the Synthesis of Chemical Compounds

The present invention provides a new route for the preparation of chemical compounds, many of which are themselves novel chemical compounds or are novel in the particular form in which they are prepared. Examples of final products which can be prepared by the present invention include (i) a coating for a printed circuit board; (ii) an encapsulant for an electrical component; (iii) a resist on a substrate which is to be plated or etched, especially a photoresist; (iv) a foam (flexible or rigid); (v) a polymeric material having covalently linked thereto a group which will act as an antioxidant, herbicide, mildewcide, fungicide, bactericide, disinfectant, deodorizer, insecticide, fertilizer, flame retardant, ultraviolet stabilizer, or catalyst; (vi) a medical diagnostic material; (vii) an ion exchange membrane; (viii) a filtration medium; (ix) an adhesive; (x) a semi-permeable membrane; (xi) an imaging film; (xii) an information storage medium; (xiii) an orthopedic cast; (xiv) a reinforcing member; (xv) a composite, e.g. an epoxy graphite composite; (xvi) a paint or a coating (including an enamel paint); (xvii) a powder coating; or (xviii) an electrically insulating coating on a conductor, e.g. an epoxy or polyester coating on a wire or a coil.

These final products, and their heat-activatable precursor compositions, form part of the present invention. Of particular interest are the myriad known uses for epoxy resins, e.g. as adhesives and prepregs, and for foamed polyurethanes or the like. Such known uses include use as adhesives in the manufacture of automobiles, and use of prepregs to reinforce concrete structures against earthquakes or against weakness caused by corrosion of reinforcing bars. Also of particular interest are unsaturated polyester thermoset resins useful for structural and functional parts in automobiles, household appliances, furniture, tools and office machines; and as building panels. The compositions are also valuable in heat-curable orthopedic casts and pressure-sensitive adhesives.

### EXAMPLES

The invention is illustrated by the following Examples. Examples 1-11 show the preparation of modifying agents, and are summarized in Table 2 below. Examples A-X show the use of the modifying agents (Examples C, F, G, H, IA and IB being comparative Examples), and Examples A-J are summarized in Table 3 below.

The ingredients (and amounts thereof in grams) used in Examples 1-6, and the properties of the products, are shown in Table 1. The following abbreviations are used in the description below and in Tables 1 and 2. C22A is docosanyl acrylate; C18A is octadecyl acrylate; C12A is dodecyl acrylate; HEA is 2-hydroxyethylacrylate; C1M is methyl methacrylate; MA is maleic anhydride; AA is acrylic acid; IEMA is isocyanatoethyl methacrylate; DMAEA is N,N-dimethylaminoethyl acrylate; VDP is vinyldiphenyl phosphine; LDA is lithium diisopropylamide; CDP is chlorodiphenyl phosphine; TBT is tri-n-butyl methacrylate; AMZ is 1-(2-aminoethyl)-2-methylimidazole; API is 1-(3-aminopropyl) imidazole; DABCO 33LV is a 33% solution of diazabicyclooctane (DABCO) in an oil carrier available from Air Products under the trade name DABCO 33 LV;AIBN is azo bis (isobutyronitrile); TAP is t-amyl peroxy 2-ethyl hexanoate; BPB is t-butyl peroxybenzoate; CBr₄ is carbon tetrabromide; C12SH is dodecane thiol; M_{w} is weight average molecular weight; Mₙ is number average molecular weight; DGEBA is the diglycidyl ether of Bisphenol A available from Shell under the tradename Epon 828; Pluracol is a hydroxy-terminated polyether available from BASF under the tradename Pluracol P 1010; Isonate is 4,4'-methylene bis(phenylsocyanate) available from Dow Chemical under the tradename Isonate 143L; DICY is dicyandiamide; Ex 1 is the spray-dried product of Example 1; similarly Ex 2, 3 and 4 are the spray-dried products of Examples 2, 3 and 4, respectively; 2X Viscosity is the time (in days unless otherwise noted) which the composition takes, at the indicated temperature, to double in viscosity.

In Example 1, a reaction mixture of C22A (180 g), IEMA (120 g), CBr₄ (10 g) and AIBN (3 g) in toluene (700 ml) was maintained at 80°C for 16 hours under nitrogen, with stirring. Excess AMZ (107 g) toluene (350 ml) and THF (100 ml) were then added to the reaction mixture, and the mixture maintained at 40-50°C with stirring for about 18 hours. After the mixture had cooled to room temperature, methanol (3 1) was added to it. The resulting precipitate was isolated by centrifuging, extraction with methanol, and drying at room temperature under reduced pressure. The product was a light yellow solid (290 g) containing no extractable AMZ by the detection method used (i.e. it contained less than 400 ppm free AMZ), and having an elemental analysis of C = 63.97%, H = 9.68% and N = 9.33%. Thus the product was a polymer containing about 51% units derived from C22A, about 27% units derived from IEMA, and about 22% units derived from AMZ, and was obtained in a yield of about 73%. The initial values of Tₒ and ΔH, as reported in Table 1, could be increased substantially by annealing the product, e.g. by maintaining it at 40-45°C for about 48 hours, or by increasing the temperature from 30 to 45°C over about 25 hours. A sample of the product (20 g) was dissolved in 100 g of a 10:1 mixture of CHCl₃ and THF, and the solution was spray dried to yield particles of size less than 5 microns (0.05 mm).

In Example 2, substantially the same procedure as in Example 1 was followed, using the ingredients shown in Table 1.

In Example 3, a reaction mixture of C22A (75 g), DMAEA (25 g), AIBN (1 g), and C12SH (1 g) in toluene (200 ml) was maintained at 60°C for 16 hours under nitrogen with stirring. The resulting polymer was precipitated by addition of ethanol, filtered, dried under reduced pressure, redissolved in CHCl₃, and spray dried. Substantially the same procedure was followed in Examples 4, 5A, 5B, 5C and 6, using the ingredients shown in Table 1.

In Example 7A, a monomer solution of C22A (58.61 g), C1M (8.60 g), MA (15.67 g) in toluene (67.12 g) was prepared at 50°C under a nitrogen atmosphere and sparged with nitrogen for fifteen minutes. A stainless steel reactor was heated to 110°C and sparged with nitrogen for 20 minutes.

The monomer solution was added to the steel reactor over a period of 15 minutes, while at the same time TAP (0.60 g) was pumped into the reactor to initiate polymerization. After two hours the solvent was removed under reduced pressure.

A 500 ml three-necked round bottom flask was equipped with a mechanical stirrer and a Dean-Stark water separator. The flask was charged with 36.3 g of the copolymer and 150 ml of toluene and heated to about 50°C . AMZ (8.76 g) was added dropwise to the copolymer solution. The reaction mixture was heated under reflux, distilling the toluene-water azeotrope, for about 18 hours. The reaction mixture was added slowly to one liter of ethyl alcohol to coagulate the polymer. The solid was collected by filtration, washed with ethyl alcohol and dried under vacuum at 50°C for 16 hours. Elemental analysis showed 17% active imidazole. Poly(docosanyl acrylate-co-methyl methacrylate-co-N(ethyl-2-(1-methyl-(2-methyl)imidazolino))maleimide characteristics are provided in Table 1.

The modifying agent was reduced in size to 5 micron average particle size using an air milling process.

In Example 7B, the same method was used as in Example 7A except that the addition of AMZ was performed below 50°C with stirring for 2 hours to form the amic acid. Then the polymer was precipitated from methanol. The material was dried under reduced pressure. This material wets the matrix faster than the material from Example 7A and yields glossier cured specimens when storage stability requirements are short. Particles were prepared with a particle size of about 5 microns by use of an air mill.

In Example 8, the same copolymer consisting of C22A/C 1 M/MA was prepared. In this example the three-necked round bottom flask was charged with 17.3 g of the copolymer and 95 ml of toluene and heated to about 50°C . API (4.16 g) was added dropwise to the copolymer solution. Elemental analysis showed 18% active imidazole. Poly(docosanyl acrylate-co-methyl methacrylate-co-N(propyl-3-(1-imidazolino))maleimide) characteristics are provided in Table 1.

The modifying agent was reduced in size to 5 micron average particle size using an air milling process.

In Example 9, a solution of C22A (62 g), VDP (25 g), BPB (1.74 g) in 100 g toluene was prepared under a nitrogen atmosphere and charged into a 500 ml round bottom flask with a stirrer. The mixture was placed in a heating oil bath at 110°C, and stirred under nitrogen for 12 hours. The reaction mixture was added slowly to 1 liter of methyl alcohol with vigorous stirring to coagulate the polymer. The solid was collected by filtration, washed with 250 ml methyl alcohol, and dried under vacuum at 50°C. Elemental analysis showed 2.7% active phosphine. Poly(docosanyl acrylate-co-vinyldiphenyl phosphine) characteristics are provided in Table 1.

In Example 10, a solution of C22A (158 g), HEA (41.6 g), C12SH (8 g), AIBN (4 g) and 200 g toluene was charged into a 1 liter screw capped glass bottle containing a magnetic stirring bar and sparged with nitrogen for 20 minutes. The bottle was placed in a water bath and stirred for 20 hours at 60°C. The reaction mixture was added slowly to 1.5 liter of methyl alcohol with stirring to precipitate the polymer. The solid was collected, washed and dried as described in Example 9.

A mixture of 150 g of C22A/HEA and 300 ml dry tetrahydrofuran was charged into a 500 ml round bottom flask under nitrogen atmosphere. The flak was immersed in a water bath to maintain the mixture at near room temperature. To the mixture was added via syringe 135 ml of 2.0 M LDA (Aldrich Chemical Co.). The mixture was stirred at room temperature for two hours. Then, 50 ml (59.5 g) CDP was added via syringe and the mixture stirred for 12 hours. A small amount of colorless solid was removed from the mixture by Buchner fitration. The filtrate was added slowly to 1 liter of methyl alcohol with stirring to precipitate the polymer. The solid was collected, washed and dried as described in Example 9. Elemental analysis showed 2.7% active phosphine. Poly(docosanyl acrylate-co-2-(diphenylphosphinoxy)ethyl acrylate) characteristics are provided in Table 1.

In Example 11, a solution of 50 g docosanyl acrylate, 50 g tri-n-butyltin methacrylate, 4 g dodecyl mercaptan, and 0.5 g AIBN was placed in a 1 liter glass reactor with a magnetic stirrer. The solution was sparged with nitrogen for 20 minutes. The reactor was sealed and was placed in a bath for 70°C for 16 hours with stirring. The reaction was added slowly to 1.5 liters of acetone with vigorous stirring to precipitate the polymer. The solid was collected by filtration, washed with acetone, and dried under vacuum at approximately 50°C for 12 hours. Elemental analysis indicated that the tin content was 14.9%. Poly(docosanyl acrylate-co-tri-n-butyltin methacrylate characteristics are provided in Table 1.

Table 2 shows ingredient quantities in grams, except as indicated otherwise. The compositions of the modifying agents are shown as % by weight.

**TABLE 2**

| | | | | | | | | | | | | | |
|---|---|---|---|---|---|---|---|---|---|---|---|---|---|
| | | | | | | | | | | | | | |

| Example | 1 | 2 | 3 | 4 | 5A | 5B | 5C | 6 | 7A&B | 8 | 9 | 10 | 11 |
|---|---|---|---|---|---|---|---|---|---|---|---|---|---|
| | | | | | | | | | | | | | |
| **Ingredients** | | | | | | | | | | | | | |
| C12A | - | - | - | - | 75 | 85 | 70 | - | - | - | - | - | 50 |
| C18A | - | - | - | - | - | - | - | 70 | - | - | - | - | - |
| C22A | 180 | 240 | 75 | 85 | - | - | - | - | 58.61 | 58.61 | 62 | 158 | - |
| C1M | - | - | - | - | - | - | - | - | 8.60 | 8.60 | - | - | - |
| MA | - | - | - | - | - | - | - | - | 15.67 | 15.67 | - | - | - |
| HEA | - | - | - | - | - | - | - | - | - | - | - | 41.6 | - |
| IEMA | 120 | 60 | - | - | - | - | - | - | - | - | - | - | - |
| DMAEA | - | - | 25 | 15 | 25 | 15 | 30 | 30 | - | - | - | - | - |
| AMZ 107 | - | - | - | - | - | - | - | - | 8.76 | - | - | - | - |
| API | - | - | - | - | - | - | - | - | - | 4.16 | - | - | - |
| LDA (2M) | - | - | - | - | - | - | - | - | - | - | - | 135 | - |
| CDP | - | - | - | - | - | - | - | - | - | - | - | 59.5 | - |
| VDP | - | - | - | - | - | - | - | - | - | - | 25 | - | - |
| TBT | - | - | - | - | - | - | - | - | - | - | - | - | 50 |
| TAP | - | - | - | - | - | - | - | - | 0.60 | 0.60 | 0.80 | - | - |
| BPB | - | - | - | - | - | - | - | - | - | - | 1.74 | - | - |
| AIBN | 3 | 3 | 1 | I | 1 | 1 | 1 | 1 | - | - | - | 4 | 0.5 |
| CBr₄ | 10 | 10 | - | - | - | - | - | - | - | - | - | - | 4 |
| C12SH | - | - | 1 | 1 | 1 | 1 | 1 | 1 | - | - | - | 8 | 4 |
| | | | | | | | | | | | | | |

| **Product** | | | | | | | | | | | | | |
|---|---|---|---|---|---|---|---|---|---|---|---|---|---|
| %C22A | 51 | 71 | 75 | 85 | - | - | - | - | 57 | 57 | 62 | 56 | 50 |
| %C12A | - | - | - | - | 88 | 92 | - | - | - | - | - | - | - |
| % IEMA | 27 | 16 | - | - | - | - | - | - | - | - | - | - | - |
| % DMAEA - | - | - | 25 | 15 | 12 | 8 | - | - | - | - | - | - | - |
| %C1M | - | - | - | - | - | - | - | - | 8.3 | 8.3 | - | - | - |
| % MA | - | - | - | - | - | - | - | - | 15.2 | 15.3. | - | - | - |
| % BPB | - | - | - | - | - | - | - | - | - | - | 17 | | - |
| % HEA | - | - | - | - | - | - | - | - | - | - | - | 15 | - |
| % AMZ | 22 | 13 | - | - | - | - | - | - | 19.5 | - | - | - | - |
| % API | - | - | - | - | - | - | - | - | - | 19 | - | - | - |
| % VDP | - | - | - | - | - | - | - | - | - | - | 21 | - | - |
| % CDP | - | - | - | - | - | - | - | - | - | - | - | 29 | - |
| % TBT | - | - | - | - | - | - | - | - | - | - | - | - | 44 |
| Tₒ (°C) | 53 | 62 | 51 | 56 | -5 | -5 | - | | 47 | 40.7 | 53.4 | 53.4 | 44 |
| Tₚ (°C) | 60 | 67 | 56 | 59 | 0 | 0 | 0 | 47 | 58 | 62.7 | 61.9 | 59.1 | 52 |
| ΔH (J/g) | 53 | 87 | 85 | 97 | 10 | 10 | - | - | 38 | 46 | 138 | 61.7 | 43 |
| | | | | | | | | | | | | | |
| M_{w} (x 1000) | 48.6 | 16. | 9.8 | 9.1 | 5.4 | 5.8 | 2.0 | 2.0 | 32.8 | 32.82 | 2.3 | 7.4 | 19 |
| Mₙ (x 1000) | 17.3 | 8.5 | 6.5 | 6.0 | 3.1 | 3.7 | - | - | 12.3 | 12.33 | 1.8 | 5.0 | 8.6 |

In Examples A to X, some of the modifying agents prepared in Examples 1 to 11 were used to prepare crosslinked polymeric resins. For Examples A to J, the ingredients used, and the properties of the resulting products, are summarized in Table 3.

In Example A, the modifying agent of Example 2 (containing C22A, IEMA and AMZ, 13%) was hand mixed with DGEBA to give 5 parts (phr) of AMZ per hundred parts of DGEBA. The resulting mixture could be stored (did not double in viscosity) at 25°C for more than 120 days and at 40°C for more than 60 days. When heated at 90°, 100° and 100°C, the composition reached the isogel point in less than 7.5, less than 5, and less than 2.5, minutes respectively. When heated from 30° to 120°C at a heating rate of 10°C per minute on a Rheometrics mechanical spectrometer, the composition reached an elastic modulus of more than 10⁷ dyn/cm² and a viscous modulus of more than 10⁶ dyn/cm² within 15 minutes. When heated from 40° to 300°C at 10°C/minute on a DSC, the cure exotherm peak commenced at 132°C, had a peak at 146°C and had a heat of reaction of 350J/g.

In Example B, the procedure of Example A was followed except that the modifying agent of Example 1 (containing C22A, IEMA and AMZ, 22%) was used in amount 3 parts of AMZ per 100 parts of DGEBA. The resulting mixture did not double in viscosity at 25°C for more than 120 days, or at 40°C for 60 days. The mechanical spectrometer data at 15 minutes and the DSC data are shown in Table 2.

In Example C, which is a comparative example, DGEBA was mixed with AMZ (5 parts per hundred). When maintained at 25°C, the mixture solidified in less than 2 days. The DSC data are shown in Table 2.

In Examples D and E, DGEBA was mixed with the modifying agents of Examples 3 and 4, respectively. The resulting mixture did not double in viscosity at 25°C for more than 120 days, or at 40°C for 60 days. The mechanical spectrometer data at 15 minutes and the DSC data are shown in Table 2.

In Examples F, G and H, which are comparative examples, Pluracol (21 g) and Isonate (5 g) were mixed together, and to the mixture was added (i) in Example F, nothing, (ii) in Example G, 1.6 g of DABCO 33LV, and (iii) in Example H, 4g of a spray-dried mixture of a copolymer of C22A and acrylic acid (85/15), 67 g, and DABCO 33LV, 46 g, so that the mixture contains 13.4% DABCO. The results of storage at 25°C are shown in Table 2.

In Example I, 15 parts of the modifying agent of Example 7, corresponding to 2.6 parts AMZ, were mixed with 100 parts ofEpon 828 epoxy resin and maintained at 40°C for 23 hours to test the latency of the polymer bound catalyst for use in curing. The polymer bound catalyst was tested for use in curing the epoxy resin by heating the formulation at 10°C/min from 30 to 300°C. The C22A/ C1M/ MA-AMZ in Epon 828 exhibited less than a 10 percent increase in viscosity after storage at 40°C for 3 months. Results are shown in Table 2.

Anhydride cured epoxy resin systems were prepared from either (1) 5.9 g of the modifying agent of Example 7 and 102 g Epon 828 and 80 g methyltetra-hydrophthalic anhydride (MeTHPA) or (2) 100 g Epon 828, 80 g MeTHPA and 1 g AMZ. Both systems were shown to cure to hard thermoset plastics on heating as demonstrated by DSC. However, whereas system (1) did not double in viscosity for at least four days at 40°C, system (2) was a hard glass in less than one day.

Furthermore, some improvement in casting clarity was obtained when the modifying agent was premixed with the MeTHPA prior to mixing with Epon 828 over mixing the modifying agent into the Epon 828 alone or into the Epon 828/ MeTHPA mixture.

When the modifying agent of 7B was employed in formulations with the Epon 828 resin, the formulation yielded higher quality coatings and adhesives, higher gloss retention and less time was required for modifying agent particle/ resin wetting than the formulation with the ring-closed maleimide. This observation may be attributed to an improved ability of the carboxyl functional group of the polymer to contact and wet the resin faster than the less polar analog.

In Example J, a formulation of 6.2 parts of modifying agent of Example 8, corresponding to 1.1 parts of API, was mixed with 100 parts of Epon 828 epoxy resin and maintained at 40°C for 43 hours to test the latency of the polymer bound catalyst for use in curing. The modifying agent/resin was tested for use in curing by heating the composition at 10°C/min from 30 to 300°C. A formulation of 15 parts of C22A/ C1M/ MA-API in 100 parts of Epon 828 exhibited less than a 10 percent increase in viscosity after storage at 40°C for 3 months.

**TABLE 3**

| EXAMPLE | A | B | C* | D | E | F* | G* | H* | I | J |
|---|---|---|---|---|---|---|---|---|---|---|
| **Ingredients** | | | | | | | | | | |
| DGEBA | Yes | Yes | Yes | Yes | Yes | - | - | - | | |
| Epon 828 | - | - | - | - | - | - | - | - | Yes | Yes |
| Pluracol | - | - | - | - | - | 21 | 21 | 21 | - | - |
| Isonate | - | - | - | - | - | 5 | 5 | 5 | - | - |
| Ex 1 | - | Yes | - | - | - | - | - | - | - | - |
| Ex 2 | Yes | - | - | - | - | - | - | - | - | - |
| Ex 3 | - | - | - | Yes | - | - | - | - | - | - |
| Ex 4 | - | - | - | - | Yes | - | - | - | - | - |
| Ex 7 | - | - | - | - | - | - | - | - | Yes | - |
| Ex 8 | - | - | - | - | - | - | - | - | - | Yes |
| AMZ | - | - | Yes | - | - | - | - | - | - | - |
| API | - | - | - | - | - | - | - | - | - | - |
| DABCO 33LV | - | - | - | - | - | - | 1.6 | - | - | - |
| C22A/AAIDABCO - | - | - | - | - | - | - | - | 4 | - | - |
| AMZ (phr) | 5 | 3 | 5 | - | - | - | - | - | 2.6 | - |
| API (phr) | - | - | - | - | - | - | - | - | - | 2.7 |
| DMAEA (phr) | - | - | - | 5 | 5 | - | - | - | - | - |
| | | | | | | | | | | |

| 2x Viscosity (days) | | | | | | | | | | |
|---|---|---|---|---|---|---|---|---|---|---|
| at 25°C | >120 | >120 | <2 | >120 | >120 | >1 min | <1 min | 20 min | - | - |
| at 40°C | >60 | >60 | - | >14 | >14 | - | - | - | >360 | >360 |

| Isogel (mins) | | | | | | | | | | |
|---|---|---|---|---|---|---|---|---|---|---|
| at 90°C | <7.5 | - | - | - | - | - | - - | - | - | - |
| at 100°C | 5 | - | - | - | - | - | - | - | - | - |
| Elastic Modulus | >10⁷ | >10⁷ | - | - | - | - | - | - | - | - |
| Viscous Modulus | >10⁶ | >10⁶ | - | - | - | - | - | - | - | - |

| DSC data | | | | | | | | | | |
|---|---|---|---|---|---|---|---|---|---|---|
| Onset (°C) Tₒ | 132 | 114 | 99 | 135 | 150 | - | - | - | 135 | 136 |
| Peak (°C) Tₚ | 146 | 137 | 130 | 200 | 195 | - | - | - | 151 | 153 |
| Heat of Reaction (J/g) | 350 | 350 | 580 | 75 | 50 | - | - | - | 385 | 229 |

| | | | | | | | | | | |
|---|---|---|---|---|---|---|---|---|---|---|
| *Comparative example | | | | | | | | | | |

### Example K

In Examples KA, KB, KC and KD, DGEBA was mixed with equivalent amounts of a tertiary amine reactant as specified below, and the mixture was used to bond together two aluminum strips 3 x 0.5 x 0. 125 inch overlapped by 0.5 inch, the mixture being cured at 95-100°C for 16 hours. The lap shear strength of the bond was measured using an Instron Load Cell at 25°C and at a rate of 0.05 inch/min. The tertiary amine reactants and the lap shear strengths are shown in Table 4 below, and demonstrate the toughening effect of the SCC polymer component.

**TABLE 4**

| | Reactant | Amount (phr) | Equivalent Weight | Lap Shear Strength |
|---|---|---|---|---|
| KA | Triethylamine | 7.9 | 101 | 1000 |
| KB | Ancamine K54 | 5.9 | 89 | 1000 |
| KC | Example 6 (C18A, DMAEA) | 37 | 477 | 2000 |
| KD | Example 5C (C12A, DMAEA) | 37 | 477 | 2000 |

### Example L

A curable pressure-sensitive ahesive was prepared by mixing 75 parts of a low T_{g} polymer (C16A/EHA/AA; 30:63:7, M_{w}=21,400 and M_{w}/Mₙ=2) with 24 parts of a crystalline polymer (C22A/GMA 80:20, M_{w}=17,400 and M_{w}/Mₙ= 1.7, and Tₘ=63°C). The mixture was briefly heated to 80°C, stirred, and then quickly cooled to 25°C, thus forming a dispersion of particles of the crystalline polymer in the low Tg polymer. To the paste obtained in this way was added one part tris(dimethylaminomethyl)phenol (K54 from Air Products). The formulation was shown to be stable by DSC and viscosity for greater than 60 days at 25°C. The system was shown to be greater than 100 times more stable at 50°C than predicted by Arrhenius kinetics from cure at 90, 110 and 130°C.

### Example M

An SCC polymer, C 18A/AA (95/5 wt%), was formed into microspheres having a median size of 33 microns, with 90% having a size less than 50 microns. Titration of a suspension of the microspheres in a poor solvent for the polymer (ethanol) yielded no detectable carboxyl functionality, while titration of a suspension in a good solvent (THF) yielded 4.75 wt% carboxyl . This demonstrates that the SCC polymer moiety, so long as it is solid, shields the carboxyl groups from the surrounding medium. A suspension of the microspheres in a 30/70 mixture of THF/ethanol was titrated first at a temperature below the polymer melt temperature, when no carboxyl groups were detected, and then at a temperature above the polymer melt temperature, when 4.6% carboxyl groups were detected.

### Example N

A cured composite was prepared using a graphite cloth supplied by Stackpole Fibers, Inc. of Lowell, Massachusetts (PANEX high modulus, high strength carbon fiber reinforcement #CFP30-05). The cloth was impregnated with the latent epoxy (SCC/tertiary amine) mixture prepared in Example B. The cloth was heated to 100°C by passing DC current through it, thus curing the resin to yield an amber-colored composite product.

### Example O

Two curable mixtures (A) and (B) were prepared by mixing at 25°C (A) 13.7 g of liquid EPON 828 with 0.7 g of liquid EMI-24 and (B) 9.2 g of EPON 828 with 0.92 g of 5 micron spherical particles, the spherical particles consisting of a 50:50 mixture of EMI-24 and SCC polymer (C22A/AA; 95/5). Mixture A, containing free EMI-24, increased in viscosity at 25°C from 76 to 4132 poise in 24 hours, while Mixture B, containing the thermally triggered particles, exhibited an increase in viscosity at 25°C from 146 to 650 poise in 24 hours.

### Example P

A curable mixture was prepared by mixing 50 g of polybutyl methacrylate supplied by Aldrich Chemical Company, 20 g of tripropyleneglycol diacrylate, 22 g of octyl acrylate, I g of benzoyl peroxide and 7 g of C22A/DMAEA polymer from Example 3. The mixture was storage stable for one week at ambient temperature and cured to a crosslinked mixture in one hour at 70°C.

Examples Q and R show the preparation of polymers which can be used, e.g. as described in Examples S and T, to produce modifying agents which contain photoactivatable chemical moieties and are useful photoresist materials.

### Example Q

Polyoctadecylacrylate (POD) was prepared by reacting together under nitrogen 1000 g of octadecyl acrylate, 25 g mercaptoethanol and 3 g AIBN in 2 liters of toluene at 65°C for 16 hours. The solution was heated at 80°C for 2 hours, then cooled to 40°C. At this time 60 g of isocyanatoethyl methacrylate and 4 drops of dibutyl tin dilaurate were added and stirred for 6 hours. The product was precipitated from ethanol and dried under reduced pressure.

351 g POD , 504 g butyl acrylate, 150 g acrylic acid in 2 liters of toluene were purged under nitrogen and polymerization initiated by addition of 10 g AIBN. The reaction proceeded at 55°C for sixteen hours, followed by heating at 80°C for two hours. The polymeric material was precipitated from methanol. Characteristics of the copolymer, poly(butyl acrylate-co-acrylic acid-co-polyoctadecyl acrylate) (PBAPOD) are shown in Table 4.

The polymer was easily coated onto a substrate and could be removed from the substrate by heating the substrate to 50°C in the presence of 0.5N aqueous sodium hydroxide.

### Example R

A monomer mixture was prepared from 1925 g octadecyl acrylate, 412 g methyl acrylate, 412 g acrylic acid, dodecyl thiol and 3 liters butyl acetate. Twenty percent of the monomer mixture was added to the polymerization vessel heated to 100°C. The remainder of the monomer mixture and 13.8 g Esperox 570 (t-amylperoxy-2-ethylhexanoate from Witco) were added to the polymerization vessel over 90 minutes. The temperature was then raised to 110°C and 13.8 g Esperox 5100 (t-amylperoxybenzoate from Witco) was added to the vessel and heated for 90 minutes. The resulting. poly(octa-decyl acrylate-co-methyl acrylate-co acrylic acid) (POMA) was dried under reduced pressure and a portion isolated. The characteristics of the polymer are shown in Table 5.

The polymer was easily coated onto a substrate and could be removed from the substrate by heating the substrate to 50°C in the presence of 0.5 N aqueous sodium hydroxide.

**TABLE 5**

| | To (°C) | Tp (°C) | Mw | Mn |
|---|---|---|---|---|
| PBAPOD | 42 | 45 | 71,000 | 17,000 |
| POMA | 35 | 41 | 85,000 | 15,800 |

### Example S

The polymer of Example R is used to prepare a modifying agent containing a photoactivatable group, Michler's ketone (4,4'-dimethyl-amino-benzophenone).

A reaction mixture is prepared consisting of POMA and Michler's ketone in a ratio corresponding to 1 equivalent of POMA carboxyl group to 1/2 equivalent of Michler's ketone. Solvent is removed by drying in vacuo. The dried polymer is formed into particles by use of an air mill.

Then about 3 parts of the photoactivatable group bound to POMA is mixed with 100 parts oftripropylene glycol diacrylate (available from PPG) and 50 parts phenoxy ethyl acrylate. The mixture is heated at 50°C in the presence of light to form copolymer.

### Example T

A polymer is prepared by the process of Example R utilizing octadecyl acrylate, methyl acrylate and hydroxy ethyl acrylate, and dodecyl mercaptan in the ratio of 70:10:20:1. The resulting polymer (POMHA) exhibited a melting point of about 39 C and a molecular weight of 8,700. 100 grams of dried POMHA is dissolved in 500 ml of tetrahydrofuran, cooled to 5 C and 0.9 equivalents of butyl lithium, based on hydroxyl groups is added dropwise while maintaining the temperature below 10 C followed by the dropwise addtion of 1.2 equivalents of 4-bromobenzophenone. The mixture is allowed to stir for 12 hours and filtered. Polymer containing attached benzophenone (POMBP) is isolated by precipitation from ethanol and dried.

### Example U

A heat and light activated film forming resin system is prepared by combining 20 parts of POMHA, 50 parts of methyl methacrylate, 10 parts of maleic anhydride and 20 parts of TPGDA at 50 C in the absence of light and subsequently cooling to room temperature. 10 parts of this resin is dissolved in 20 ml of toluene and coated onto a polyester film at a dry film thickness of 48 microns and subsequently covered with a 38 micron film of polyethylene to produce a laminatable photoresist.

### Example V

A mixture consisting of 3 g RF713 (conductive silver epoxy resin from Resin Formulators Division of EV Roberts, Inc.) and 0.16 g of the latent curing agent prepared in Example 7 was prepared. A second mixture consisting of 3 g RF713 and 0.03g of 2-ethyl-4-methylimidazole (EMI-24 available from Air Products) was prepared. Each mixture was heated in a hot press between aluminum plates at 177°C and disks Were formed 6.6 mm in diameter and 3.1 mm in thickness. Using a multimeter, the disks exhibited equivalent resistance of about 5 ohms.

### Example W

Example W shows how the addition of a co-additive to a modifying agent/resin mixture reduces the time required for the modifying agent to effectively wet the resin. A mixture of 13.6 g of the modifying agent of Example 1, 4% by weight of W-990 based on the weight of the modifying agent, and 100 g of Epon 828 epoxy resin was prepared and tested in a thin film consisting of a 250 micron thick adhesive band line. The modifying agent wet the resin in 4 days at 40°C compared with 3 months at the same temperature in the absence of the wetting agent.

### Example X

Example X shows how the addition of a co-additive improves the aesthetic and mechanical characterisitics of a thermoset resin. The system of example I was evaluated with and without nonyl phenol. 14 parts nonyl phenol yielded glossy, clear thermosets at 80°C. Curing at 120°C required less than 3 parts of nonyl phenol to achieve the same high gloss, clear, uniform thermosets. Without nonyl phenol the system cured to a flat finish at 120°C; between 80-120C the system cured to a phase separated thermoset that had poor gloss and poor clarity

## Claims

1. A latent composition which comprises
(1) a first reactive component; and
(2) mixed with the first reactive component, a second reactive component which is in the form of solid particles, and which, when the composition is heated; promotes a chemical reaction of the first reactive component,
**characterized in that**
I the first reactive component is in the form of a continuous liquid or solid phase matrix material; and
II the second reactive component is a latent modifying agent is in the form of solid particles which
(a) have an average size of less than 150 microns;
(b) are composed of a polymeric material which comprises
(i) a polymeric moiety which comprises a crystalline polymeric moiety having an onset of melting temperature Tₒ and a peak melting temperature Tₚ , Tₚ being greater than 30 °C and such that (Tₚ- Tₒ) is less than Tₚ ^{0.7}, and
(ii) an active chemical moiety which, when it is brought into contact with the matrix material at a temperature of at least Tₚ, promotes a chemical reaction of the matrix material;
(c) have some of the active chemical moieties exposed on the surface of the particles and the other active chemical moieties hidden within the particles;
(d) are contacted by the matrix material; and
(e) have a heat of fusion of at least 20 J/g; and
Tₒ and Tₚ being in °C., and Tₒ, Tₚ and the heat of fusion being determined using a differential scanning calorimeter (DSC) at a rate of temperature change of 10°C/min;
and further **characterized in that** the composition fulfills at least one of the following conditions:
(A) Tₚ is not more than 100°C;
(B) the polymeric moiety comprises a side chain crystalline polymeric moiety which (i) comprises units derived from one or more monomers containing an n-alkyl group containing 12 to 50 carbon atoms, and (ii) has a peak melting temperature Tₚ of at least 40 °C;
(C) the active chemical moiety catalyzes a chemical reaction of the matrix material; and
(D) the matrix material comprises a cyanoacrylate, epoxy resin, epoxy novolac, unsaturated polyester, cyanate, isocyanate, urethane, acrylic, phenolic, silicone or polysulfide;
whereby, if the composition is heated from Tₒ to a temperature of at least Tₚ, the polymeric moiety melts, thus causing the modifying agent to undergo a physical change which increases the extent of the contact between the matrix material and the active chemical moiety and promotes the chemical reaction of the matrix material.

2. A composition according to Claim 1 **characterized in that** the polymeric moiety comprises a side chain crystalline polymeric moiety which (i) comprises units derived from one or more monomers containing an n-alkyl group containing 12 to 50 carbon atoms and (ii) has a peak melting temperature Tₚ of at least 40 °C.

3. A composition according to Claim 1 or 2, **characterized in that** (a) the matrix material is a precursor for a thermoset polymer, and (b) if the composition is heated from Tₒ to a temperature of at least Tₚ, the chemical reaction promoted by the active chemical moiety converts the matrix material into a thermoset polymer.

4. A composition according to Claim 3, **characterized in that** the matrix material comprises an epoxy resin or an epoxy novolac.

5. A composition according to Claim 4, **characterized in that** matrix material comprises an epoxy resin and dicyandiamide or an anhydride.

6. A composition according to any one of claims 1 to 3, **characterized in that** the matrix material comprises an unsaturated polyester.

7. A composition according to any one of the preceding claims, **characterized in that** the matrix material comprises a cyanate, a urethane, an acrylic or a phenolic.

8. A composition according to any one of the preceding claims, **characterized in that** the active chemical moiety contains nitrogen.

9. A composition according to any one of the preceding claims, **characterized in that** the active chemical moiety is a catalytic moiety which, when the composition is heated to a temperature of at least Tₚ, catalyzes a chemical reaction of matrix material.

10. A composition according to Claim 9, **characterized in that** the catalytic moiety comprises a transition metal.

11. A composition according to any one of claims 1 to 8, **characterized in that** the active chemical moiety (i) is covalently bonded to the polymeric moiety of the modifying agent, and (ii) is a moiety which, when the composition is heated to a temperature of at least Tₚ, forms a permanent chemical bond with the matrix material.

12. A composition according to any one of preceding claims, **characterized in that** the modifying agent is present in the form of particles having an average size of 0.1 to 10 microns.

13. A composition according to any one of the preceding claims, **characterized in that** it also contains an additive which contains (i) one or more non-polar groups which are alkyl, fluoroalkyl or alkyl styrene groups in which the alkyl group contains at least 6 carbon atoms, and (ii) one or more polar groups which are epoxy, hydroxyl, carboxyl, amino, ammonium, ether, ester, amide, sulfonamide, sulfonic acid, sulfonic acid salt or phosphate groups.

14. A composition according to any one of preceding claims, **characterized in that** it also contains an additive which is a partial salt of an acidic polyester or an n-alkylphenol in which the alkyl group contains 6 to 20 carbon atoms.

15. A composition according to any one of the preceding claims, **characterized in that** it is being stored at 20-30 °C, Tₚ is 45 to 85 °C, and (Tₚ-Tₒ) is less than 10 °C.

16. A composition according to any one of the preceding claims, **characterized in that** the active chemical moiety is bonded to the polymeric moiety by a covalent bond.

17. A composition according to any one of claims 1 to 15, **characterized in that** the active chemical moiety is bonded to the polymeric moiety by a mixed covalent-ionic bond.

18. A composition according to any one of claims 1 to 15, **characterized in that** the active chemical moiety is bonded to the polymeric moiety by a ligand-attached bond.

19. A composition according to any one of claims 1 to 15, **characterized in that** the active chemical moiety is bonded to the polymeric moiety by Van der Waal bonds.

20. A composition according to any one of claims 1 to 18, **characterized in that** the active chemical moiety is bonded to the polymeric moiety through a bond having a strength of at least 10 Kcal/mole.

21. A composition according to any one of the preceding claims, **characterized in that** it can be stored for at least one month at 40 °C without doubling in viscosity.

22. A method of making a chemical compound which comprises heating a composition as claimed in any one of the preceding claims to a temperature of at least Tₚ.

23. A temperature-sensitive modifying agent which is in the form of solid particles which
(a) have an average size of less than 150 microns;
(b) are composed of a polymeric material which comprises
(i) a polymeric moiety which comprises a side chain crystalline polymeric moiety having an onset of melting temperature Tₒ and a peak melting temperature Tₚ, Tₚ being greater than 30 °C and such that (Tₚ- Tₒ) is less than Tₚ^{0.7} , and
(ii) an active chemical moiety which comprises a transition metal;
(c) have some of the active chemical moieties exposed on the surface of the particles and the other active chemical moieties hidden within the particles; and
(d) have a heat of fusion of at least 20 J/g;
Tₒ and Tₚ being in °C, and Tₒ, Tₚ and the heat of fusion being determined using a differential scanning calorimeter at a rate of temperature change of 10 °C/min.

24. A modifying agent according to Claim 23, **characterized in that** the solid particles have an average size of 0.1 to 10 microns.

25. A modifying agent according to Claim 23 or 24, **characterized in that** the active chemical moiety is bonded to the polymeric moiety through a bond having a strength of at least 10 kcal/mole.

## Patentansprüche

1. Latente Zusammensetzung, die
(1) eine erste reaktive Komponente und
(2) gemischt mit der ersten reaktiven Komponente eine zweite reaktive Komponente umfasst, die in Form fester Teilchen vorliegt und, wenn die Zusammensetzung erwärmt wird, eine chemische Reaktion der ersten reaktiven Komponente fördert, **dadurch gekennzeichnet, dass**
I die erste reaktive Komponente in Form eines kontinuierlichen Flüssig- oder Festphasematrixmaterials vorliegt und
II die zweite reaktive Komponente ein latenter Regler in Form von festen Teilchen ist, die
(a) eine durchschnittliche Größe von weniger als 150 µm aufweisen,
(b) aus einem polymeren Material zusammengesetzt sind, das
(i) einen polymeren Anteil, der einen kristallinen polymeren Anteil mit einer Anfangsschmelztemperatur Tₒ und einer Peakschmelztemperatur Tₚ umfasst, wobei Tₚ höher als 30°C und so ist, dass (Tₚ-Tₒ) weniger als Tₚ^{0,7} ist, und
(ii) einen aktiven chemischen Anteil umfasst, der, wenn er mit dem Matrixmaterial bei einer Temperatur von mindestens Tₚ in Kontakt gebracht wird, eine chemische Reaktion des Matrixmaterials fördert,
(c) einige aktive chemische Anteile freiliegend auf der Oberfläche der Teilchen und andere aktive chemische Anteile verborgen in den Teilchen aufweisen,
(d) von dem Matrixmaterial kontaktiert werden und
(e) eine Schmelzwärme von 20 J/g haben,
wobei Tₒ und Tₚ in °C angegeben sind und Tₒ, Tₚ und die Schmelzwärme unter Verwendung eines Differenzialscanningkalorimeters (DSC) bei einer Temperaturänderungsgeschwindigkeit von 10°C/min bestimmt werden;
und weiterhin **dadurch gekennzeichnet, dass** die Zusammensetzung mindestens eine der folgenden Bedingungen erfüllt:
(A) Tₚ ist nicht höher als 100°C,
(B) der polymere Anteil umfasst einen kristallinen polymeren Seitenkettenanteil, der (i) von einem oder mehreren Monomeren abgeleitet ist, die eine n-Alkylgruppe mit 12 bis 50 Kohlenstoffatomen enthalten, und (ii) eine Peakschmelztemperatur Tₚ von mindestens 40°C aufweist,
(C) der aktive chemische Anteil katalysiert eine chemische Reaktion des Matrixmaterials, und
(D) das Matrixmaterial umfasst ein Cyanoacrylat, Epoxyharz, Epoxynovolak, ungesättigten Polyester, Cyanat, Isocyanat, Urethan, Acrylharz, Phenolharz, Silikon oder Polysulfid,
wobei, wenn die Zusammensetzung von Tₒ auf eine Temperatur von mindestens Tₚ erwärmt wird, der polymere Anteil schmilzt und dadurch bewirkt, dass der Regler einer physikalischen Veränderung unterliegt, die das Ausmaß des Kontaktes zwischen dem Matrixmaterial und dem aktiven chemischen Anteil erhöht und die chemische Reaktion des Matrixmaterials fördert.

2. Zusammensetzung nach Anspruch 1, **dadurch gekennzeichnet, dass** der polymere Anteil einen kristallinen polymeren Seitenkettenanteil umfasst, der (i) von einem oder mehreren Monomeren abgeleitete Einheiten umfasst, die eine n-Alkylgruppe mit 12 bis 50 Kohlenstoffatomen enthalten, und (ii) eine Peakschmelztemperatur Tₚ von mindestens 40°C aufweist.

3. Zusammensetzung nach Anspruch 1 oder 2, **dadurch gekennzeichnet, dass** (a) das Matrixmaterial ein Vorläufer für einen Duroplast ist und (b) die chemische Reaktion, die von dem aktiven chemischen Anteil gefördert wird, das Matrixmaterial in einen Duroplast umwandelt, wenn die Zusammensetzung von Tₒ auf eine Temperatur von mindestens Tₚ erwärmt wird.

4. Zusammensetzung nach Anspruch 3, **dadurch gekennzeichnet, dass** das Matrixmaterial ein Epoxyharz oder ein Epoxynovolak umfasst.

5. Zusammensetzung nach Anspruch 4, **dadurch gekennzeichnet, dass** das Matrixmaterial ein Epoxyharz und Dicyandiamid oder ein Anhydrid umfasst.

6. Zusammensetzung nach einem der Ansprüche 1 bis 3, **dadurch gekennzeichnet, dass** das Matrixmaterial einen ungesättigten Polyester umfasst.

7. Zusammensetzung nach einem der vorangehenden Ansprüche, **dadurch gekennzeichnet, dass** das Matrixmaterial ein Cyanat, ein Urethan, ein Acrylharz oder ein Phenolharz umfasst.

8. Zusammensetzung nach einem der vorangehenden Ansprüche, **dadurch gekennzeichnet, dass** der aktive chemische Anteil Stickstoff enthält.

9. Zusammensetzung nach einem der vorangehenden Ansprüche, **dadurch gekennzeichnet, dass** der aktive chemische Anteil ein katalytischer Anteil ist, der eine chemische Reaktion des Matrixmaterials katalysiert, wenn die Zusammensetzung auf eine Temperatur von mindestens Tₚ erwärmt wird.

10. Zusammensetzung nach Anspruch 9, **dadurch gekennzeichnet, dass** der katalytische Anteil ein Übergangsmetall umfasst.

11. Zusammensetzung nach einem der Ansprüche 1 bis 8, **dadurch gekennzeichnet, dass** der aktive chemische Anteil (i) kovalent an den polymeren Anteil des Reglers gebunden ist und (ii) ein Anteil ist, der eine permanente chemische Bindung mit dem Matrixmaterial bildet, wenn die Zusammensetzung auf eine Temperatur von mindestens Tₚ erwärmt wird.

12. Zusammensetzung nach einem der vorangehenden Ansprüche, **dadurch gekennzeichnet, dass** der Regler in Form von Teilchen vorliegt, die eine durchschnittliche Größe von 0,1 bis 10 µm haben.

13. Zusammensetzung nach einem der vorangehenden Ansprüche, **dadurch gekennzeichnet, dass** sie außerdem ein Additiv enthält, das (i) ein oder mehrere nicht polare Gruppen, die Alkyl-, Fluoroalkyl- oder Alkylstyrolgruppen sind, in denen die Alkylgruppe mindestens 6 Kohlenstoffatome enthält, und (ii) eine oder mehrere polare Gruppen enthält, die Epoxy-, Hydroxyl-, Carboxyl-, Amino-, Ammonium-, Ether-, Ester-, Amid-, Sulfonamid-, Sulfonsäure-, Sulfonsäuresalz- oder Phosphatgruppen sind.

14. Zusammensetzung nach einem der vorangehenden Ansprüche, **dadurch gekennzeichnet, dass** sie außerdem ein Additiv enthält, das ein Teilsalz eines sauren Polyesters oder eines n-Alkylphenols, in dem die Alkylgruppe 6 bis 20 Kohlenstoffatome enthält, ist.

15. Zusammensetzung nach einem der vorangehenden Ansprüche, **dadurch gekennzeichnet, dass** sie bei 20-30°C gelagert wird, Tₚ 45 bis 85°C ist und (Tₚ-Tₒ) weniger als 10°C beträgt.

16. Zusammensetzung nach einem der vorangehenden Ansprüche, **dadurch gekennzeichnet, dass** der aktive chemische Anteil an dem polymeren Anteil durch eine kovalente Bindung gebunden ist.

17. Zusammensetzung nach einem der Ansprüche 1 bis 15, **dadurch gekennzeichnet, dass** der aktive chemische Anteil durch eine gemischte kovalente-ionische Bindung an den polymeren Anteil gebunden ist.

18. Zusammensetzung nach einem der Ansprüche 1 bis 15, **dadurch gekennzeichnet, dass** der aktive chemische Anteil durch eine ligandvermittelte Bindung an den polymeren Anteil gebunden ist.

19. Zusammensetzung nach einem der Ansprüche 1 bis 15, **dadurch gekennzeichnet, dass** der aktive chemische Anteil durch Van der Waalsche Bindungen an den polymeren Anteil gebunden ist.

20. Zusammensetzung nach einem der Ansprüche 1 bis 18, **dadurch gekennzeichnet, dass** der aktive chemische Anteil durch eine Bindung mit einer Stärke von mindestens 10 Kcal/Mol an den polymeren Anteil gebunden ist.

21. Zusammensetzung nach einem der vorangehenden Ansprüche,
**dadurch gekennzeichnet, dass** sie mindestens einen Monat lang ohne Verdopplung der Viskosität bei 40°C gelagert werden kann.

22. Verfahren zur Herstellung einer chemischen Verbindung, bei dem eine Zusammensetzung gemäß einem der vorangehenden Ansprüche auf eine Temperatur von mindestens Tₚ erwärmt wird.

23. Temperaturempfindlicher Regler, der in Form von festen Teilchen vorliegt, die
(a) eine durchschnittliche Größe von weniger als 150 µm aufweisen,
(b) aus einem polymeren Material zusammengesetzt sind, das
(i) einen polymeren Anteil, der einen kristallinen polymeren Seitenkettenanteil mit einer Anfangsschmelztemperatur Tₒ und einer Peakschmelztemperatur Tₚ umfasst, wobei Tₚ höher als 30°C und so ist, dass (Tₚ-Tₒ) weniger als Tₚ^{0,7} ist, und
(ii) einen aktiven chemischen Anteil umfasst, der ein Übergangsmetall umfasst,
(c) einige aktive chemische Anteile auf der Oberfläche der Teilchen und andere aktive chemische Anteile verborgen in den Teilchen aufweisen und
(d) eine Schmelzwärme von 20 J/g haben,
wobei Tₒ und Tₚ in °C angegeben sind und Tₒ, Tₚ und die Schmelzwärme unter Verwendung eines Differenzialscanningcalorimeters bei einer Temperaturänderungsgeschwindigkeit von 10°C/min bestimmt werden.

24. Regler nach Anspruch 23, **dadurch gekennzeichnet, dass** die festen Teilchen eine durchschnittliche Größe von 0,1 bis 10 µm haben.

25. Regler nach Anspruch 23 oder 24, **dadurch gekennzeichnet, dass** der aktive chemische Anteil durch eine Bindung mit einer Stärke von mindestens 10 kcal/ Mol an den polymeren Anteil gebunden ist.

## Revendications

1. Composition latente qui comprend :
(1) un premier composant réactif ; et
(2) mélangé avec le premier composant réactif, un second composant réactif qui se présente sous la forme de particules solides, et qui, lorsque la composition est chauffée, active une réaction chimique du premier composant réactif,
**caractérisée par le fait que** :
I le premier composant réactif se présente sous la forme d'une matière de matrice en phase liquide ou solide continue ; et
II le second composant réactif est un agent modifiant latent qui se présente sous la forme de particules solides qui
(a) ont une dimension moyenne de moins de 150 microns ;
(b) sont composées d'une matière polymère qui comprend
(i) une fraction polymère qui comprend une fraction polymère cristalline ayant un début de température de fusion Tₒ et une température de fusion de pic Tₚ, Tₚ étant supérieur à 30°C et tel que (Tₚ - Tₒ) est inférieur à Tₚ^{0,7} ; et
(ii) une fraction chimique active qui, lorsqu'elle est amenée en contact avec, la matière de matrice à une température d'au moins Tₚ, active une réaction chimique de la matière de matrice ;
(c) ont certaines des fractions chimiques actives exposées sur la surface des particules et les autres fractions chimiques actives cachées à l'intérieur des particules ;
(d) sont en contact avec la matière de matrice ; et
(e) ont une chaleur de fusion d'au moins 20 J/g ; et
Tₒ et Tₚ étant exprimés en °C, et Tₒ, Tₚ et la chaleur de fusion étant déterminées à l'aide d'un calorimètre différentiel (DSC) à une vitesse de changement de température de 10°C/min ;
et **caractérisée en outre par le fait que** la composition remplit au moins l'une des conditions suivantes :
(A) Tₚ ne dépasse pas 100°C ;
(B) la fraction polymère comprend une fraction polymère cristalline à chaînes latérales qui (i) comprend des unités provenant d'un ou plusieurs monomères contenant un groupe n-alkyle contenant 12 à 50 atomes de carbone, et (ii) présente une température de fusion de pic Tₚ d'au moins 40°C ;
(C) la fraction chimique active catalyse une réaction chimique de la matière de matrice ; et
(D) la matière de matrice comprend un cyanoacrylate, une résine époxy, un époxy novolaque, un polyester insaturé, un cyanate, un isocyanate, un uréthane, un acrylique, un phénolique, un silicone ou un polysulfure ;
ce par quoi, si la composition est chauffée de Tₒ à une température d'au moins Tₚ, la fraction polymère fond, amenant ainsi l'agent modifiant à subir un changement physique qui augmente l'étendue du contact entre la matière de matrice et la fraction chimique active et active la réaction chimique de la matière de matrice.

2. Composition selon la revendication 1, **caractérisée par le fait que** la fraction polymère comprend une fraction polymère cristalline à chaînes latérales qui (i) comprend des unités provenant d'un ou plusieurs monomères contenant un groupe n-alkyle contenant 12 à 50 atomes de carbone et (ii) a une température de fusion de pic Tₚ d'au moins 40°C.

3. Composition selon l'une des revendications 1 ou 2, **caractérisée par le fait que** (a) la matière de matrice est un précurseur pour un polymère thermodurci, et (b) si la composition est chauffée de Tₒ à une température d'au moins Tₚ, la réaction chimique activée par la fraction chimique active convertit la matière de matrice en un polymère thermodurci.

4. Composition selon la revendication 3, **caractérisée par le fait que** la matière de matrice comprend une résine époxy ou un époxy novolaque.

5. Composition selon la revendication 4, **caractérisée par le fait que** la matière de matrice comprend une résine époxy et le dicyandiamide ou un anhydride.

6. Composition selon l'une quelconque des revendications 1 à 3, **caractérisée par le fait que** la matière de matrice comprend un polyester insaturé.

7. Composition selon l'une quelconque des revendications précédentes, **caractérisée par le fait que** la matière de matrice comprend un cyanate, un uréthane, un acrylique ou un phénolique.

8. Composition selon l'une quelconque des revendications précédentes, **caractérisée par le fait que** la fraction chimique active contient de l'azote.

9. Composition selon l'une quelconque des revendications précédentes, **caractérisée par le fait que** la fraction chimique active est une fraction catalytique qui, lorsque la composition est chauffée à une température d'au moins Tₚ, catalyse une réaction chimique de la matière de matrice.

10. Composition selon la revendication 9, **caractérisée par le fait que** la fraction catalytique comprend un métal de transition.

11. Composition selon l'une quelconque des revendications 1 à 8, **caractérisée par le fait que** la fraction chimique active (i) est liée de façon covalente à la fraction polymère de l'agent modifiant, et (ii) est une fraction qui, lorsque la composition est chauffée à une température d'au moins Tₚ, forme une liaison chimique permanente avec la matière de matrice.

12. Composition selon l'une quelconque des revendications précédentes, **caractérisée par le fait que** l'agent modifiant est présent sous la forme de particules ayant une dimension moyenne de 0,1 à 10 microns.

13. Composition selon l'une quelconque des revendications précédentes, **caractérisée par le fait qu'**elle contient également un additif qui contient (i) un ou plusieurs groupes non-polaires, qui sont des groupes alkyle, fluoroalkyle ou alkyl styrène dans lesquels le groupe alkyle contient au moins 6 atomes de carbone, et (ii) un ou plusieurs groupes polaires qui sont des groupes époxy, hydroxyle, carboxyle, amino, ammonium, éther, ester, amide, sulfonamide, acide sulfonique, sel d'acide sulfonique ou phosphate.

14. Composition selon l'une quelconque des revendications précédentes, **caractérisée par le fait qu'**elle contient un additif qui est un sel partiel d'un polyester acide ou un n-alkyl phénol dans lequel le groupe alkyle contient 6 à 20 atomes de carbone.

15. Composition selon l'une quelconque des revendications précédentes, **caractérisée par le fait qu'**étant stockée à 20-30°C, Tₚ est 45 à 80°C, et (Tₚ-Tₒ) est inférieur à 10°C.

16. Composition selon l'une quelconque des revendications précédentes, **caractérisée par le fait que** la fraction chimique active est liée à la fraction polymère par une liaison covalente.

17. Composition selon l'une quelconque des revendications 1 à 15, **caractérisée par le fait que** la fraction chimique active est liée à la fraction polymère par une liaison covalente-ionique mixte.

18. Composition selon l'une quelconque des revendications 1 à 15, **caractérisée par le fait que** la fraction chimique active est liée à la fraction polymère par une liaison attachée par ligand.

19. Composition selon l'une quelconque des revendications 1 à 15, **caractérisée par le fait que** la fraction chimique active est liée à la fraction polymère par des liaisons de Van der Waals.

20. Composition selon l'une quelconque des revendications 1 à 18, **caractérisée par le fait que** la fraction chimique active est liée à la fraction polymère par l'intermédiaire d'une liaison ayant une force d'au moins 10 kcal/mole.

21. Composition selon l'une quelconque des revendications précédentes, **caractérisée par le fait qu'**elle peut être stockée pendant au moins un mois à 40°C sans doubler de viscosité.

22. Procédé de fabrication d'un composé chimique qui comprend le chauffage d'une composition telle que définie à l'une quelconque des revendications précédentes à une température d'au moins Tₚ.

23. Agent modifiant sensible à la température qui se présente sous la forme de particules solides qui
(a) ont une dimension moyenne de moins de 150 microns ;
(b) sont composées d'une matière polymère qui comprend :
(i) une fraction polymère qui comprend une fraction polymère cristalline à chaînes latérales ayant un début de température de fusion Tₒ et une température de fusion de pic Tₚ, Tₚ étant supérieure à 30°C et telle que Tₚ=Tₒ) est inférieure à Tₚ^{0,7} et
(ii) une fraction chimique active qui comprend un métal de transition ;
(c) ont certaines des fractions chimiques actives exposées sur la surface des particules et les autres fractions chimiques actives cachées à l'intérieur des particules ; et
(d) ont une chaleur de fusion d'au moins 20 J/g ;
Tₒ et Tₚ étant exprimées en °C, et Tₒ, Tₚ et la chaleur de fusion étant déterminées à l'aide d'un calorimètre différentiel à une vitesse de changement de température de 10°C/min.

24. Agent modifiant selon la revendication 23, **caractérisé par le fait que** les particules solides ont une dimension moyenne de 0,1 à 10 microns.

25. Agent modifiant selon l'une des revendications 23 ou 24, **caractérisé par le fait que** la fraction chimique active est liée à la fraction polymère par l'intermédiaire d'une liaison ayant une force d'au moins 10 kcal/mole.
